# EUROPEAN PATENT APPLICATION

(11) **EP 2 787 375 A1**
(43) Date of publication of application: **08.10.2014**
(21) Application number: 12853282.7
(22) Date of filing: 14.11.2012
(51) Int. Cl.: G02B 5/02, H01L 51/50, H05B 33/02, H05B 33/10

(54) **LIGHT-DIFFUSING TRANSFER MATERIAL, METHOD FOR FORMING LIGHT DIFFUSION LAYER, ORGANIC ELECTROLUMINESCENT DEVICE, AND METHOD FOR MANUFACTURING ORGANIC ELECTROLUMINESCENT DEVICE**

(30) Priority: 30.11.2011 JP 2011262828
(71) Applicant: FUJIFILM Corporation, Tokyo 106-0031 (JP)
(72) Inventor: MOROHASHI Kana, Ashigarakami-gun Kanagawa 258-8577 (JP); TOBISE Manabu, Ashigarakami-gun Kanagawa 258-8577 (JP)
(74) Representative: HOFFMANN EITLE
(86) International application number: PCT/JP2012/079525
(87) International publication number: WO 2013/080798

(57) **Abstract**

An object is to provide a light-diffusing transfer material which is excellent in transferring property and may form a light diffusion layer which may enhance the light extraction efficiency of an organic electroluminescent device, and provided is a light-diffusing transfer material including at least one light-diffusing particle and an organic film containing at least one high refractive index inorganic filler on a support, in which a content ratio of the light-diffusing particle in the organic film is 25% by volume to 50% by volume.

## Description

### Technical Field

The present invention relates to a light-diffusing transfer material, a method for forming a light diffusion layer, an organic electroluminescent device, and a method for manufacturing an organic electroluminescent device.

### Background Art

An organic electroluminescent (organic EL) device is a self-emission type display device, and expected as the use of display or lighting. For example, an organic electroluminescent display has advantages in display performance, such as high visibility and no viewing angle dependence compared to the CRT or LCD in the related art. Further, the organic electroluminescent display is also advantageous in that the display may be made lighter and thinner. On the other hand, an organic electroluminescent lighting has a possibility that lighting in a shape, which has not been realized so far, may be realized by using a flexible substrate, in addition to the advantages of lighter and thinner.

In general, the organic electroluminescent device has a configuration in which a transparent electrode, an organic layer including a light emitting layer, and a back electrode (reflective electrode) are laminated on a transparent substrate. Light emitted from the organic layer is reflected directly or from the back electrode, and is emitted from the transparent substrate side and the transparent electrode side. The organic electroluminescent device has excellent characteristics as described above, but the refractive index of the transparent electrode or the organic layer is higher than that of air, and it is easy for the emitted light to be totally reflected from the interface. For that reason, the light extraction efficiency as a device does not reach 20%, and most of the emitted light is lost.

In order to enhance the light extraction efficiency, there has been proposed an organic electroluminescent device in which a light diffusion layer (light scattering layer) is formed between a transparent substrate and a transparent electrode. For example, Patent Document 1 describes an organic electroluminescent element in which a light diffusion layer obtained by dispersing at least two particles having different average particle diameters by one or more digits in a resin is formed adjacent to a transparent electrode on a light extraction surface side.

As a method for forming the light diffusion layer, a forming method by a transfer method has been studied in addition to an application method.

For example, Patent Document 2 describes a light scattering layer transfer material in which a light-transmitting resin and a light scattering layer containing light scattering particles having an average particle diameter of 50 to 300 nm are formed on a temporary support. Herein, an example is described, in which a surface of the transfer material at the light scattering layer side is bonded to a transfer-receiving material (an organic EL device in which an organic layer, an electrode and the like are formed), and the light scattering layer is transferred by heating or irradiation of laser light.

Even in a display such as an LCD in addition to the organic electroluminescent (organic EL) device, a light diffusion layer in which light scattering particles are contained in a resin is formed for the purpose of making light from a light source uniform and the like. As a method for forming a light diffusion layer in a display such as an LCD, a transfer method is also used.

For example, Patent Document 3 describes a light diffusion layer transfer sheet in which an uncured optical diffusion layer including an ionized radiation curable resin and particles as an optical diffusing agent and having adhesion property is formed on a support, and describes a method for transferring the uncured optical diffusion layer to a transfer-receiving material by being bonded to the transfer-receiving material and performing pressurization and heating, or a method for dropping an optical diffusion layer by photoirradiation, and then bonding the optical diffusion layer to the transfer-receiving material to transfer the optical diffusion layer after curing to the transfer-receiving material.

In addition, Patent Document 4 describes a forward scattering film having a light scattering layer which includes ionized radiation and spherical particles on a support, and describes a method for transferring a forward scattering film to a transfer-receiving material by bonding the forward scattering film to the transfer-receiving material, subjecting the assembly to patterning irradiation with ionized radiation to cure the irradiated portion, and changing adhesion strength with the support.

### Citation List

### Patent Document

Patent Document 1: Japanese Patent Application Laid-Open No. 2005-190931
Patent Document 2: Japanese Patent Application Laid-Open No. 2009-259802
Patent Document 3: Japanese Patent Application Laid-Open No. 2005-121811
Patent Document 4: Japanese Patent Application Laid-Open No. 2001-264518

### Summary of Invention

### Problems to be solved

From the viewpoint of enhancing the light extraction efficiency in an organic electroluminescent device, a light diffusion layer is required to forward scatter light from an organic layer and have a high refractive index in order to prevent light from the organic layer from being totally reflected at an interface with a transparent substrate. In particular, in order to sufficiently forward scatter light, it is preferred that light scattering particles are contained at a predetermined ratio or more. In the light scattering layer transfer material of Patent Document 2, the ratio of light scattering particles in the light scattering layer is as low as 10% or less by a volume filling ratio.

Furthermore, in Patent Documents 3 and 4, light scattering particles are used in a light scattering layer, but the content ratio of particles in the layer or making the layer have a high refractive index is not mentioned. The refractive index of the light scattering layer, which is conjectured from the embodiments of Patent Document 3 or 4, is about 1.6, which is a value insufficient for a light diffusion layer in the organic electroluminescent device. Furthermore, since scattering of light becomes strong when the content ratio of particles is increased, photocuring of a resin is not likely to be sufficiently achieved.

Furthermore, when the light diffusion layer is formed by a transfer method, high transferring property, that is, transfer is required to be performed without leaving a film. In the forward scattering film of Patent Document 4, the light scattering layer is transferred by using a change in adhesion strength of the light scattering layer with the support according to the curing of the resin by irradiation of ionized radiation. From the viewpoint of enhancing the light extraction efficiency, when the ratio of light scattering particles in the forward scattering film of Patent Document 4 is increased, scattering of light is increased by the effects of the particles, so that the resin is not likely to be sufficiently cured, and as a result, there is a concern in that transfer and manufacturing deteriorates because insufficient curing causes a film to remain in the support.

In consideration of the above-described situations, an object of the present invention is to provide a light-diffusing transfer material which is excellent in transferring property and is capable of forming a light scattering layer which may enhance the light extraction efficiency of an organic electroluminescent device. Another object of the present invention is to provide a method for forming a light diffusion layer, which is capable of forming a light diffusion layer which may enhance the light extraction efficiency of an organic electroluminescent device. Still another object of the present invention is to provide an organic electroluminescent device which is excellent in light extraction efficiency and a method for manufacturing the same.

### Means for Solving the Problems

Means for solving the problems are as follows.
(1) A light-diffusing transfer material including at least one light-diffusing particle and an organic film containing at least one high refractive index inorganic filler on a support, in which a content ratio N [% by volume] of the light-diffusing particle in the organic film is in a range from 25 to 50, and a thickness T [µm] of the organic film satisfies T ≥ 150 N.
(2) The light-diffusing transfer material described in (1), in which a film thickness of the organic film is 4 µm to 15 µm.
(3) The light-diffusing transfer material described in (1) or (2), in which the support is composed of at least one selected from polyethylene terephthalate, polyethylene naphthalate, polyvinyl alcohol and polyvinyl chloride.
(4) A method for forming a light diffusion layer, the method including: bonding a surface having an organic film in the light-diffusing transfer material described in any one of (1) to (3) to a transfer-receiving material, and transferring the organic film to the transfer-receiving material under a condition of a heating temperature of 60°C or more to form the light diffusion layer on the transfer-receiving material.
(5) The method described in (4), in which the heating temperature is 80°C to 150°C.
(6) The method described in (4) or (5), in which the organic film is cured by irradiating ionized radiation on the organic film in the air while the light-diffusing transfer material is bonded to the transfer-receiving material.
(7) The method described in (4) or (5), in which the organic film is cured by irradiating ionized radiation on the organic film after transferring the organic film to the transfer-receiving material to peel-off the support from the organic film.
(8) A method for manufacturing an organic electroluminescent device having a substrate, a light diffusion layer, a transparent electrode, an organic electroluminescent layer and a reflective electrode in this order,
   the method including: a step of forming the light diffusion layer by the forming method described in any one of (4) to (7).
(9) The method described in (8), including a step of forming the light diffusion layer on the substrate by using the substrate as a transfer-receiving material.
(10) An organic electroluminescent device manufactured by the manufacturing method described in (8) or (9).

### Effect of Invention

According to the present invention, it is possible to provide a light-diffusing transfer material which is excellent in transferring property and is capable of forming a light diffusion layer which may enhance the light extraction efficiency of an organic electroluminescent device. Further, it is possible to form a light diffusion layer which may enhance the light extraction efficiency of an organic electroluminescent device. In addition, it is possible to provide an organic electroluminescent device which is excellent in light extraction efficiency and a method for manufacturing the same.

### Brief Description of Drawings

FIG. 1 is a view schematically illustrating an example of a method for forming a light diffusion layer of the present invention.
FIG. 2 is a schematic view illustrating an example of an organic electroluminescent device of the present invention.
FIG. 3 is a schematic view illustrating another example of the organic electroluminescent device of the present invention.
FIG. 4 is a schematic view illustrating still another example of the organic electroluminescent device of the present invention.

### Embodiments for Carrying Out the Invention

### [Light-Diffusing Transfer Material]

A light-diffusing transfer material of the present invention includes at least one light-diffusing particle and an organic film containing at least one high refractive index inorganic filler on a support, in which a content ratio N [% by volume] of the light-diffusing particle in the organic film is in a range from 25 to 50, and a thickness T [µm] of the organic film satisfies T ≥ 150 N.

### (Support)

A support in the light-diffusing transfer material of the present invention is not particularly limited as long as the support may be used as a support of the transfer material. As a material for the support, a resin publicly known in the related art may be used, and specific examples thereof include polyethylene terephthalate (PET), polyethylene naphthalate (PEN), polyvinyl alcohol (PVA), polyvinyl chloride (PVC), polycarbonate, polyethylene, polypropylene, triacetyl cellulose and the like. From the viewpoint of mechanical strength, chemical and thermal stability, gas barrier property and economic efficiency, the material is preferably polyethylene terephthalate, polyethylene naphthalate, polyvinyl alcohol and polyvinyl chloride, and more preferably polyethylene terephthalate.

The thickness of the support is preferably 50 µm to 2,000 µm, more preferably 200 µm to 1,500 µm, and even more preferably 500 µm to 1,000 µm.

For the purpose of enhancing peeling-off property with the organic film from the viewpoint of enhancing transferring property, the support may be subjected to mold release processing. Examples of a method of the mold release processing include a method for coating a silicone-based polymer or a fluorine polymer, a method for depositing a fluorine compound, a method for coating a fluorine-based or fluorine silicone-based silane coupling agent, and the like. The method is preferably a processing by a fluorine silicone-based silane coupling agent.

### (Organic Film)

An organic film in the light-diffusing transfer material of the present invention includes an organic material as a main component form forming the film, and contains at least one light-diffusing particle and at least one high refractive index inorganic filler, and other components if necessary.

### «Organic Material»

An organic material, which forms the organic film, is not particularly limited, and may be appropriately selected according to the purpose thereof. Examples thereof include (1) a thermoplastic resin, (2) a reactive curable resin, (3) a curable compound (a curable polyfunctional monomer or polyfunctional oligomer and the like to be described below), and the like.

### - (1) Thermoplastic Resin -

(1) The thermoplastic resin is not particularly limited, and may be appropriately selected according to the purpose thereof, and examples thereof include a polystyrene resin, a polyester resin, a cellulose resin, a polyether resin, a vinyl chloride resin, a vinyl acetate resin, a vinyl chloride-vinyl acetate copolymer resin, a polyacrylic resin, a polymethacrylic resin, a polyolefin resin, a urethane resin, a silicone resin, an imide resin and the like. The thermoplastic resins may be used either alone or in combination of two or more thereof. Among them, a polyacrylic resin and a polymethacrylic resin are preferred, a polyacrylic resin and a polymethacrylic resin, which are derived from acryl or methacryl having a fluorene structure, are more preferred, and a polyacrylic resin having a fluorene structure is particularly preferred.

### - (2) Reactive Curable Resin -

(2) It is preferred that as the reactive curable resin, a thermosetting type resin and/or an ionized radiation curing type resin are/is used.

The thermosetting type resin is not particularly limited, and may be appropriately selected according to the purpose thereof, and examples thereof include a phenol resin, a urea resin, a diallyl phthalate resin, a melamine resin, a guanamine resin, an unsaturated polyester resin, a polyurethane resin, an epoxy resin, an aminoalkyd resin, a melamine-urea co-condensation resin, a silicone resin, a polysiloxane resin and the like.

The ionized radiation curing type resin is not particularly limited, and may be appropriately selected according to the purpose thereof, and examples thereof include resins having a functional group such as a radical-polymerizable unsaturated group {a (meth)acryloyloxy group, a vinyloxy group, a styryl group, a vinyl group and the like} and/or a cationic polymerizable group (an epoxy resin, a thioepoxy resin, a vinyloxy group, an oxetanyl group and the like), and examples of the resins include a polyester resin, a polyether resin, a (meth)acrylic resin, an epoxy resin, a urethane resin, an alkyd resin, a spiroacetal resin, a polybutadiene resin, a polythiolpolyene resin and the like, which have a relatively low molecular weight. The resins may be used either alone or in combination of two or more thereof.

Meanwhile, the "ionized radiation" refers to a radiation which affects an ionized action on a material by irradiation thereof, and includes alpha rays, gamma rays, X rays, ultraviolet rays, visible light rays, electron beams and the like. In the present invention, ultraviolet rays and electron beams are preferred, and ultraviolet rays are particularly preferred.

When these reactive curable resins are used, it is preferred that if necessary, a curing agent such as a crosslinking agent (an epoxy compound, a polyisocyanate compound, a polyol compound, a polyamine compound, a melamine compound and the like) and a polymerization initiator (a UV photo-initiator such as an azobis comound, an organic peroxide compound, an organic halogen compound, an onium salt compound and a ketone compound, and the like) and a compound publicly known in the related art, such as a polymerization accelerator (an organic metal compound, an acid compound, a basic compound and the like) are used in combination. Specific examples thereof include the compounds described in Shinzo Yamashita and Tousuke Kaneko "Handbook of Crosslinking Agent" (published by TAISEISHA LTD. in 1981).

### - (3) Curable Compound -

(3) The curable compound refers to a compound which is cured by a crosslinking or polymerization reaction by irradiation of ionized radiation, and examples thereof include a polyfunctional monomer, a polyfunctional oligomer and the like.

A functional group of the polyfunctional monomer or the polyfunctional oligomer may be any one of a radical polymerizable functional group and a cationic polymerizable group.

Examples of the radical polymerizable functional group include an ethylenically unsaturated group such as a (meth)acryloyl group, a vinyloxy group, a styryl group and an ally group. Among them, a (meth)acryloyl group is particularly preferred, and it is particularly preferred to contain a polyfunctional monomer containing two or more radical polymerizable groups in the molecule.

It is preferred that the radical polymerizable polyfunctional monomer is selected from the compounds having at least two terminal ethylenically unsaturated bonds. The monomer is preferably a compound having two to six terminal ethylenically unsaturated bonds in the molecule. The group of these compounds is widely known in the field of polymer materials, and may be used in the present invention without any particular limitation. These compounds may have chemical forms such as a monomer, a prepolymer (that is, a dimer, a trimer and an oligomer) or mixtures thereof and copolymers thereof, for example.

Examples of the radical polymerizable monomer include unsaturated carboxylic acids (for example, acrylic acid, methacrylic acid, itaconic acid, crotonic acid, isocrotonic acid, maleic acid and the like), or esters and amides thereof and the like. Among them, esters of unsaturated carboxylic acids with aliphatic polyhydric alcohol compounds and amides of unsaturated carboxylic acids with aliphatic polyhydric amine compounds are particularly preferred.

Further, addition reaction products of unsaturated carboxylic acid esters or amides, which have a nucleophilic substituent such as a hydroxyl group, an amino group and a mercapto group, with monofunctional or polyfunctional isocyanates or epoxies, dehydration condensation reaction products of the unsaturated carboxylic acid esters or amides with a polyfunctional carboxylic acid, and the like are also suitably used. In addition, reaction products of unsaturated carboxylic acid esters or amides having an electrophilic substituent such as an isocyanate group or an epoxy group with monofunctional or polyfunctional alcohols, amines and thiols are also suitable. Furthermore, as another example, the group of compounds substituted with an unsaturated phosphonic acid, styrene and the like may also be used instead of the aforementioned unsaturated carboxylic acids.

Examples of the aliphatic polyfunctional alcohol compound include alkanediol, alkanetriol, cyclohexanediol, cyclohexanetriol, inositol, cyclohexanedimethanol, pentaerythritol, sorbitol, dipentaerythritol, tripentaerythritol, glycerin, diglycerin and the like. Examples of polymerizable ester compounds (monoesters and polyesters) of these aliphatic polyhydric alcohol compounds with unsaturated carboxylic acids include the compounds described in paragraph nos. [0026] and [0027] of Japanese Patent Application Laid-Open No. 2001-139663.

As other polymerizable esters, for example, vinyl methacrylate, allyl methacrylate, allyl acrylate, aliphatic alcohol-based esters described in Japanese Patent Publication Nos. S46-27926 and S51-47334 and Japanese Patent Application Laid-Open No. S57-196231 and the like, esters having an aromatic structure as described in Japanese Patent Application Laid-Open No. H2-226149 and the like, esters having an amino group described in Japanese Patent Application Laid-Open No. H1-165613, and the like are also suitably used.

Furthermore, specific examples of a polymerizable amide formed of aliphatic polyhydric amine compounds and unsaturated carboxylic acids include methylenebis(meth)acrylamide, 1,6-hexamethylenebis(meth)acrylamide, diethylenetriaminetris(meth)acrylamide, xylylenebis(meth)acrylamide, compounds having a cyclohexylene structure described in Japanese Patent Publication No. S54-21726, and the like.

Furthermore, it is also possible to use vinyl urethane compounds containing two or more polymerizable vinyl groups in one molecule (the Japanese Patent Publication No. S48-41708 and the like), urethane acrylates (Japanese Patent Publication No. H2-16765 and the like), urethane compounds having an ethylene oxide-based structure (Japanese Patent Publication No. S62-39418 and the like), polyester acrylates (Japanese Patent Publication No. S52-30490 and the like), and photocurable monomers and oligomers described in the Journal of the Adhesion Society of Japan, Vol. 20, No. 7, pp. 300 to 308 (1984). Two or more of these radical polymerizable polyfunctional monomers may be used in combination.

As the cationic polymerizable group-containing compound (hereinafter, also referred to as the "cationic polymerizable compound" or the "cationic polymerizable organic compound), it is possible to use any compound that causes a polymerization reaction and/or a crosslinking reaction when irradiated with ionized radiation in the presence of an ionized radiation-sensitive cationic polymerization initiator, and representative examples thereof include an epoxy compound, a cyclic thioether compound, a cyclic ether compound, a spiro-ortho ester compound, a vinyl hydrocarbon compound, a vinyl ether compound and the like. One or two or more of the cationic polymerizable organic compounds may be used.

As cationic polymerizable group-containing compound, the number of cationic polymerizable groups in one molecule is preferably 2 to 10, and more preferably 2 to 5. The weight average molecular weight of the compound is preferably 3,000 or less, more preferably 200 to 2,000, and even more preferably 400 to 1,500. When the weight average molecular weight is 200 or more, there is no case where volatilization during film formation becomes a problem and the like, and when the weight average molecular weight is 3,000 or less, there arises no problem such as deterioration in the compatibility with another component of the organic film, which is preferred.

Examples of the epoxy compound include an aliphatic epoxy compound, an aromatic epoxy compound and the like.

Examples of the aliphatic epoxy compound include homopolymers and copolymers such as polyglycidyl ether of aliphatic polyhydric alcohol or an alkylene oxide adduct thereof, polyglycidyl ester of aliphatic long chain polybasic acid, glycidyl acrylate or glycidyl methacrylate, and the like. Furthermore, in addition to the above epoxy compounds, examples thereof include monoglycidyl ether of aliphatic higher alcohol, glycidyl ester of higher fatty acid, epoxidized soybean oil, butyl epoxystearate, octyl epoxystearate, epoxidized linseed oil, epoxidized polybutadiene and the like. Further, examples of the alicyclic epoxy compounds include polyglycidyl ether of polyhydric alcohol having at least one alicyclic ring, compounds containing cyclohexene oxide or cyclopentene oxide obtained by epoxidizing compounds containing an unsaturated alicyclic ring (for example, cyclohexene, cyclopentene, dicyclooctene, tricyclodecene and the like) with a proper oxidizing agent such as hydrogen peroxide and peracid, and the like.

Examples of the aromatic epoxy compound include mono- or polyglycidyl ether of monohydric or polyhydric phenol having at least one aromatic nucleus or an alkylene oxide adduct thereof. Examples of these epoxy compounds include the compounds described in paragraph nos. [0084] to [0086] of Japanese Patent Application Laid-Open No. H11-242101, the compounds described in paragraph nos. [0044] to [0046] of Japanese Patent Application Laid-Open No. H10-158385, and the like.

Among these epoxy compounds, in consideration of a rapid curing property, aromatic epoxide and alicyclic epoxide are preferred, and alicyclic epoxide is more preferred. The epoxy compounds may be used alone, but may be appropriately used in combination of two or more.

Examples of the cyclic thioether compounds include compounds having a thioepoxy ring instead of the epoxy ring of the epoxy compound.

Specific examples of the compounds containing an oxetanyl group as the cyclic ether compound include the compounds described in paragraph nos. [0024] and [0025] of Japanese Patent Application Laid-Open No. 2000-239309. It is preferred that these compounds are used in combination with epoxy group-containing compounds.

Examples of the spiro-ortho ester compounds include the compounds described in Japanese Unexamined Patent Application Publication No. 2000-506908.

Examples of the vinyl hydrocarbon compounds include styrene compounds, vinyl group-substituted alicyclic hydrocarbon compounds (vinylcyclohexane, vinylbicycloheptene and the like), the compounds as described in the above radical polymerizable monomer, propenyl compounds {those described in "J. Polymer Science: Part A: Polymer Chemistry", Vol. 32, p. 2895 (1994), and the like), alkoxyallene compounds {those described in "J. Polymer Science: Part A: Polymer Chemistry", Vol. 33, p. 2493 (1995), and the like}, vinyl compounds {those described in "J. Polymer Science: Part A: Polymer Chemistry", Vol. 34, p. 1015 (1996), Japanese Patent Application Laid-Open No. 2002-29162 and the like), isopropenyl compounds {those described in "J. Polymer Science: Part A: Polymer Chemistry", Vol. 34, p. 2051 (1996), and the like}, and the like. These compounds may be appropriately used in combination of two or more.

In addition, it is preferred that as the polyfunctional compound, a compound at least containing each of at least one selected from the aforementioned radical polymerizable groups and cationic polymerizable groups in the molecule is used. Examples thereof include the compounds described in paragraph nos. [0031] to [0052] of Japanese Patent Application Laid-Open No. H8-277320, the compounds described in paragraph no. [0015] of Japanese Patent Application Laid-Open No. 2000-191737, and the like. The compound used in the present invention are not limited thereto.

The radical polymerizable compound and the cationic polymerizable compound as described above are contained in a ratio of preferably 90:10 to 20:80, and more preferably 80:20 to 30:70, as a mass ratio of the radical polymerizable compound : the cationic polymerizable compound.

### - Polymerization Initiator -

When using the curable compound, it is preferred to use a polymerization initiator in combination. Examples of the polymerization initiator include a thermal polymerization initiator, a photopolymerization initiator and the like.

As the polymerization initiator, a compound which generates a radical or an acid by irradiation of light and/or heat is preferred. The maximum absorption wavelength of the polymerization initiator is preferably 400 nm or less. By setting absorption wavelength in the ultraviolet region as described above, the polymerization initiator may be handled under white light. Furthermore, compounds having maximum absorption wavelength in the near infrared region may also be used.

The radical-generating compound refers to a compound which generates a radical by irradiation of light and/or heat to initiate and accelerate the polymerization of a compound having a polymerizable unsaturated group. It is possible to appropriately select and use a publicly known polymerization initiator or a compound having a bond which is small in bond and dissociation energy and the like. Further, the radical-generating compounds may be used either alone or in combination of two or more thereof.

Examples of the radical-generating compound include thermal radical polymerization initiators such as organic peroxide compounds publicly known in the related art and azo-based polymerization initiators, and photo radical polymerization initiators such as organic peroxide compounds (Japanese Patent Application Laid-Open No. 2001-139663, and the like), amine compounds (described in Japanese Patent Publication No. S44-20189), metallocene compounds (described in Japanese Patent Application Laid-Open Nos. H5-83588 and H1-304453, and the like), hexaarylbiimidazole compounds (described in U.S. Patent No. 3,479,185 and the like), disulfone compounds (Japanese Patent Application Laid-Open Nos. H5-239015 and S61-166544, and the like), organic halide compounds, carbonyl compounds, organic boric acid compounds, phosphine oxide compounds, and phosphonate compounds. The radical generating agent is more preferably a phosphine oxide compound and a phosphonate compound, particularly preferably acylphosphine oxide, acyl phosphonate and the like, and specifically bis(2,4,6-trimethyl benzoyl)-phenyl phosphine oxide.

Specific examples of the organic halide compounds include the compounds described in Wakabayashi et al., "Bull. Chem. Soc. Japan", Vol. 42, pp. 2924 (1969), U.S. Patent No. 3,905,815, Japanese Patent Application Laid-Open No. H5-27830, M.P. Hutt, "J. Heterocyclic Chemistry", Vol. 1 (No. 3), (1970) and the like, and in particular, oxazole compounds substituted with a trihalomethyl group : s-triazine compounds. More suitable examples thereof include s-triazine derivatives in which at least one mono-, di- or trihalogen-substituted methyl group is bonded to the s-triazine ring.

Examples of the carbonyl compound include the compounds described in "The Latest Techniques of UV Curing", pp. 60 to 62 [published by Technical Information Institute Co., Ltd. in 1991], paragraph nos. [0015] and [0016] of Japanese Patent Application Laid-Open No. H8-134404, and paragraph nos. [0029] to [0031] of Japanese Patent Application Laid-Open No. H11-217518, and the like. In addition, examples thereof include acetophenone-based, hydroxyacetophenone-based, benzophenone-based and thioxane-based compounds, benzoin compounds such as benzoin ethyl ether and benzoin isobutyl ehter, benzoic ester derivatives such as ethyl p-dimethylaminobenzoate and ethyl p-diethylaminobenzoate, benzyl dimethyl ketal, acylphosphine oxide and the like.

Examples of the organic borate compounds include the compounds described in organic borates described in each patent documents such as Japanese Patent No. 2764769 and Japanese Patent Application Laid-Open No. 2002-116539, Kunz, Martin, "Rad Tech 98. Proceeding April 19 to 22, 1998, Chicago" and the like. Examples thereof include the compounds described in paragraph nos. [0022] to [0027] of Japanese Patent Application Laid-Open No. 2002-116539. Furthermore, specific examples of other organic boron compounds include organoboron transition metal coordination complexes described in Japanese Patent Application Laid-Open Nos. H6-348011, H7-128785, H7-140589, H7-306527 and H7-292014, and the like.

As these radical-generating compounds, only one may be added, or two or more thereof may be used in combination. The addition amount is preferably 0.1% by mass to 30% by mass, more preferably 0.5% by mass to 25% by mass, and even more preferably 1% by mass to 20% by mass, based on the total amount of the radical polymerizable monomer. In the range of the addition amount, the radical-generating compound becomes highly polymerizable without a problem of stability over time in the organic film.

Subsequently, a photo-acid generator, which may be used as a photopolymerization initiator, will be described in detail.

Examples of the photo-acid generator include publicly known compounds and mixtures thereof and the like, such as a publicly known photo-acid generator which is used in a photo-initiator for cationic photopolymerization, a photodecoloring agent for dyes, a photodiscoloring agent, a micro resist and the like. Further, examples of the photo-acid generator include organic halide compounds, disulfone compounds, onium compounds and the like. Among them, organic halide compounds and disulfone compounds are particularly preferred. Specific examples of the organic halide compounds and the disulfone compounds include those described in the compounds which generate a radical.

Examples of the onium compounds include diazonium salts, ammonium salts, iminium salts, phosphonium salts, iodonium salts, sulfonium salts, arsonium salts, selenonium salts and the like, and the compounds described, for example, in paragraph nos. [0058] and [0059] of Japanese Patent Application Laid-Open No. 2002-29162.

As the acid generator, an onium salt is particularly suitably used, and among them, diazonium salts, iodoinium salts, sulfonium salts and iminium salts are preferred in terms of photosensitivity of photopolymerization initiation, material stability of the compound and the like.

Specific examples of the onium salts include, for example, amylated sulfonium salts described in paragraph [0035] of Japanese Patent Application Laid-Open No. H9-268205, diaryl iodonium salts and triaryl sulfonium salts described in paragraph nos. [0010] and [0011] of Japanese Patent Application Laid-Open No. 2000-71366, sulfonium salts of thiobenzoic acid S-phenylester described in paragraph no. [0017] of Japanese Patent Application Laid-Open No. 2001-288205, onium salts described in paragraph nos. [0030] to [0033] of Japanese Patent Application Laid-Open No. 2001-133696, and the like.

Other examples of the photo-acid generator include compounds such as an organic metal/organic halide, a photo-acid generator having an o-nitrobenzyl type protective group and a compound which undergoes photodecomposition to generate sulfonic acid (iminosulfonate and the like), which are described in paragraph nos. [0059] to [0062] of Japanese Patent Application Laid-Open No. 2002-29162.

These acid generators may be used either alone or in combination of two or more thereof. The addition amount of the acid generator is preferably 0.1% by mass to 20% by mass, more preferably 0.5% by mass to 15% by mass, and even more preferably 1% by mass to 10% by mass, based on the total mass of the cationic polymerizable monomer. The addition amount within the above range is preferred due to stability, polymerization-reactivity and the like of the organic film.

The radical polymerization initiator or the cationic polymerization initiator is contained preferably at a ratio of 0.5% by mass to 10% by mass or 1% by mass to 10% by mass, respectively, and more preferably at a ratio of 1% by mass to 5% by mass or 2% by mass to 6% by mass, respectively, based on the combined mass of the radical polymerizable compound or the cationic polymerizable compound.

The refractive index of the binder (that after curing in the case of the organic material, the reactive and curable resin, and the curable compound) constituting the organic film is preferably 1.7 to 2.2, more preferably 1.7 to 2.1, and even more preferably 1.7 to 2.0. When the refractive index falls within the range, it is suitable for enhancing the light extraction efficiency of an organic electroluminescent device using a light diffusion layer formed of an organic film.

### «Light-Diffusing Particle>>

A light-diffusing particle used in an organic film of the light-diffusing transfer material of the present invention is not particularly limited as long as the particle may diffuse light, and may be appropriately selected according to the purpose thereof, may be an organic particle or an inorganic particle, and may contain two or more particles.

Examples of the organic particle include a polymethyl methacrylate particle, a crosslinked polymethyl methacrylate particle, an acryl-styrene copolymer particle, a melamine particle, a polycarbonate particle, a polystyrene particle, a crosslinked polystyrene particle, a polyvinyl chloride particle, a benzoguanamine-melamine formaldehyde particle and the like. Examples of the inorganic particle include ZrO₂, TiO₂, Al₂O₃, In₂O₃, ZnO, SnO₂, Sb₂O₃ and the like. Among them, TiO₂, ZrO₂, ZnO and SnO₂ are particularly preferred.

Among them, as the light-diffusing particle, a resin particle in a crosslinked state is preferred, and a crosslinked polymethyl methacrylate particle is particularly preferred, in terms of solvent resistance and dispersibility in the binder.

It may be confirmed by observing how difficult for the resin particle to be dissolved by dispersing the resin particle in a solvent, for example, toluene that the light-diffusing particle is a resin particle in a crossed state.

The refractive index of the light-diffusing particle is not particularly limited, and may be appropriately selected according to the purpose thereof, and is preferably 1.0 to 3.0, more preferably 1.2 to 1.6, and even more preferably 1.3 to 1.5. When the refractive index falls within the range, light diffusing property (scattering property) in the light diffusion layer formed of an organic film becomes good, so that the refractive index is suitable for enhancing the light extraction efficiency of an organic electroluminescent device using the light diffusion layer.

The refractive index of the light diffusion particle may be measured with a precision spectrometer (GMR-1DA, manufactured by Shimadzu Corporation) by the Shrivsky method after measuring the refractive index of a refractive index liquid using, for example, an automated refractive index meter (KPR-2000, manufactured by Shimadzu Corporation).

In the present invention, the difference in refractive indices |A-B| (absolute value) between a refractive index A of a binder (that after curing in the case of the organic material, the curable resin, and the curable compound) and a refractive index B of the light-diffusing particle in the organic film is 0.2 to 1.0, preferably 0.2 to 0.5, and even more preferably 0.2 to 0.4. When the difference in refractive indices |A-B| falls within the range, light diffusing property (scattering property) in the light diffusion layer formed of an organic film becomes good, so that the difference in refractive indices |A-B| is suitable for enhancing the light extraction efficiency of an organic electroluminescent device using the light diffusion layer.

The average particle diameter of the light-diffusing particle is preferably 0.5 µm to 10 µm, more preferably 0.5 µm to 6 µm, and even more preferably 1 µm to 3 µm. When the average particle diameter of the light-diffusing particle is 10 µm or less, the particle diameter is preferred for obtaining appropriate light diffusing property (scattering property). Meanwhile, when the average particle diameter of the light-diffusing particle is 0.5 µm or more, the dependence of the scattering efficiency of the light-diffusing particle on wavelength is small and a change in chromaticity of an organic electroluminescent device using a light diffusion layer formed of an organic film is small, so that the average particle diameter is preferred for enhancing the light extraction efficiency.

The average particle diameter of the light-diffusing particle may be measured by a device using a dynamic light scattering method, such as, for example, NANOTRAC UPA-EX150 manufactured by Nikkiso Co., Ltd. or image processing of the electron micrographs.

The content ratio of the light-diffusing particle in the organic film is 25% by volume to 50% by volume, preferably 25% by volume to 40% by volume, and more preferably 30% by volume to 35% by volume. In consideration of the organic electroluminescent device using a light-diffusing layer formed of an organic film, when the content ratio is less than 25% by volume, it is less likely that light incident to the light diffusion layer is scattered by the light-diffusing particle, and the capability of converting the light angle of the light diffusion layer is small, so that the light extraction efficiency may be decreased in some cases when the thickness of the light diffusion layer is not maintained at a sufficiently high level. In addition, increasing the thickness of the light diffusion layer leads to an increase in costs and the variation in thickness of the light diffusion layer becomes large, so that there is a concern that a variation in the scattering effect of the light emission in-plane occurs. Meanwhile, when the content ratio exceeds 50% by volume, the surface of the light diffusion layer is greatly roughened and voids are also produced therein, so that a physical strength of the light diffusion layer may be decreased in some cases.

Furthermore, stress is imposed at the interface with the light-diffusing particle by a shrinkage in volume produced when the curable resin or the curable compound is cured and the film strength is decreased, and accordingly, transferring property also deteriorates. When the content ratio of the light-diffusing particle in the organic film falls within the range, stress between the light-diffusing particle and the curable compound may be suppressed, so that the transferring property of the organic film is enhanced.

«High Refractive Index Inorganic Filler»

A high refractive index inorganic filler used in the organic film of the light-diffusing transfer material of the present invention is not particularly limited as long as the filler has a high refractive index, but examples thereof include inorganic particles such as metal oxide.

Examples of the metal of the metal oxide include zirconium, titanium, aluminum, indium, zinc, tin, chromium, antimony and the like. Specific examples of the metal oxide include ZrO₂, TiO₂, Al₂O₃, In₂O₃, ZnO, SnO₂, Sb₂O₃, ITO, Cr₂O₃ and the like. Among them, TiO₂ (titanium oxide) is particularly preferred.

As a titanium oxide particle, titanium oxide particles with inactivated photocatalyst activity are preferred from the viewpoint of stability over time. The titanium oxide particles with inactivated photocatalyst activity are not particularly limited as long as the particles do not have a photocatalyst activity, and may be appropriately selected according to the purpose thereof, but examples thereof include (1) titanium oxide particles obtained by covering the surface of the titanium oxide particle with at least one of alumina, silica and zirconia, (2) titanium oxide particles obtained by covering the covered surface of the covered titanium oxide particle in (1) with a resin, and the like. Examples of the resin include polymethyl methacrylate (PMMA) and the like.

It may be confirmed by, for example, a methylene blue method that the titanium oxide particles with inactivated photocatalyst activity do not have a photocatalyst activity.

The titanium oxide particle in the titanium oxide particles with inactivated photocatalyst activity is not particularly limited, and may be appropriately selected according to the purpose thereof, and as the crystal structure, a crystal structure including rutile, mixed crystal of rutile/anatase, and anatase as main components is preferred, and a crystal structure including a rutile structure as a main component is particularly preferred.

The titanium oxide particles may be complexed by adding metal oxide other than titanium oxide.

As a metal oxide which may complex the titanium oxide particles, at least one metal oxide selected from Sn, Zr, Si, Zn and Al is preferred.

The amount of the metal oxide added in titanium is preferably 1% by mol to 40% by mol, more preferably 2% by mol to 35% by mol, and even more preferably 3% by mol to 30% by mol.

The primary average particle diameter of the high refractive index inorganic filler is preferably 1 nm to 30 nm, more preferably 1 nm to 25 nm, and even more preferably 1 nm to 20 nm. The primary average particle diameter may be measured, for example, by a calculation from a half-width of a diffraction pattern measured with an X-ray diffraction device, a statistical calculation from the diameters of an image captured by an electron microscope (TEM), and the like.

The shape of the high refractive index inorganic filler is not particularly limited, and may be appropriately selected according to the purpose thereof, and for example, a rice grain shape, a ball shape, a cubic shape, a spindle shape or an amorphous shape is preferred. The high refractive index inorganic fillers may be used either alone or in combination of two or more thereof.

The high refractive index inorganic filler has a refractive index of 2.2 to 3.0, more preferably 2.2 to 2.8, and even more preferably 2.2 to 2.6. When the refractive index falls within the range, it is possible to effectively increase the refractive index of an organic film and a light diffusion layer formed of the organic film without coloring the light diffusion layer. Herein, it is difficult to measure the refractive index of a particle having a high refractive index (1.8 or more) and an average primary particle diameter in a range from 1 to 100 nm, but the refractive index may be measured as follows. A resin material having an already known refractive index is doped with the high refractive index inorganic filler, and the resin material in which the high refractive index inorganic filler is dispersed is used to form a coating film on a Si substrate or a quartz substrate. The refractive index of the coating film may be measured by an ellipsometer, and the refractive index of the titanium oxide particle may be known from the volume fraction of the resin material and the titanium oxide particle, which constitute the coating film.

The content ratio of the high refractive index inorganic filler in the organic film is 10% by volume to 30% by volume, more preferably 10% by volume to 25% by volume, and even more preferably 10% by volume to 20% by volume with respect to the organic material from the viewpoint of the light extraction efficiency of the organic electroluminescent device using the light diffusion layer formed of the organic film.

### <<Thickness of Organic Film>>

In the light-diffusing transfer material of the present invention, the thickness T [µm] of the organic film and the content ratio N [% by volume] of the light-diffusing particle in the organic film satisfy the relationship T ≥ 150/N. Preferably, T ≥ 200/N, and more preferably, T ≥ 220/N. Further, the upper limit is preferably T ≤ 400/N, and more preferably, T ≤ 370/N. The thickness of the organic film is preferably 4 µm to 15 µm, more preferably 4 µm to 12 µm, and particularly preferably 4 µm to 9 µm. In consideration of an organic electroluminescent device using a light diffusion layer formed of an organic film, when the thickness falls within the range, an appropriate light diffusing property may be obtained, so that the thickness is suitable for enhancing the light extraction efficiency.

In addition, when the thickness of the organic film falls within the range, stress generated at the interface with the substrate, which is generated during heating may be reduced, so that transferring property of the organic film is enhanced.

The thickness of the organic film may be obtained, for example, by cutting a part of the organic film and measuring the part with a scanning type electron microscope (S-3400N, manufactured by Hitachi High Technologies Co.).

### «Method for Forming Organic Film»

The organic film may be formed by applying a coating composition in which the organic material, the light-diffusing particle, the high refractive index inorganic filler, and the like and if necessary, a solvent are mixed on the support, and drying the coating composition.

The solvent is not particularly limited, and may be appropriately selected according to the purpose thereof, and examples thereof include alcohols, ketones, esters, amides, ethers, ether esters, aliphatic hydrocarbons, halogenated hydrocarbons and the like. Specific examples thereof include alcohol (for example, methanol, ethanol, propanol, butanol, benzyl alcohol, ethylene glycol, propylene glycol, ethylene glycol monoacetate and the like), ketone (for example, methyl ethyl ketone, methyl isobutyl ketone, cyclohexanone, methylcyclohexanone and the like), ester (for example, methyl acetate, ethyl acetate, propyl acetate, butyl acetate, ethyl formate, propyl formate, butyl formate, ethyl lactate and the like), aliphatic hydrocarbon (for example, hexane, cyclohexane and the like), halogenated hydrocarbon (for example, methyl chloroform and the like), aromatic hydrocarbon (for example, benzene, toluene, xylene, ethylbenzene and the like), amide (for example, dimethylformamide, dimethylacetamide, n-methylpyrrolidone and the like), ether (for example, dioxane, tetrahydrofuran, ethylene glycol dimethyl ether, propylene glycol dimethyl ether and the like), and ether alcohol (for example, 1-methoxy-2-propanol, ethyl cellosolve, methyl carbinol and the like). The compounds may be used either alone or in combination of two or more thereof. Among them, aromatic hydrocarbon and ketones are preferred, toluene, xylene, methyl ethyl ketone, methyl isobutyl ketone and cyclohexanone are more preferred, and toluene and xylene are particularly preferred.

The organic film may be manufactured by applying the coating composition on a substrate, by a publicly known method for forming a thin film, such as a dip coating method, an air knife coating method, a curtain coating method, a roller coating method, a wire bar coating method, a gravure coating method, a micro gravure coating method, and an extrusion coating method, and drying the coating composition.

### (Cover Film)

In order to protect the light-diffusing transfer material of the present invention from contamination or damage during storage, a cover film may be formed on the organic film.

The cover film may be composed of a material which is the same as or similar to the support, and a cover film which may be easily separated from the organic film is preferred. As a material for the cover film, for example, silicone paper and polyolefin or polytetrafluoroethylene sheets are preferred, and a polyethylene film or a polypropylene film is more preferred.

The thickness of the cover film is preferably 5 µm to 100 µm, and more preferably 15 µm to 50 µm.

### [Method for Forming Light Diffusion Layer]

In a method for forming a light diffusion layer according to the present invention, a surface having the organic film of the above-described light-diffusing transfer material of the present invention is adhered to a transfer-receiving material (herein, when a cover film is formed, the cover film is peeled off and bonded to the transfer-receiving material), and the organic film is transferred to the transfer-receiving material under the condition of a heating temperature of 60°C or more to form a light diffusion layer on the transfer-receiving material.

The organic film of the light-diffusing material transfer of the present invention may be transferred on a transfer-receiving material favorably in terms of transferring property without leaving the film by bonding the organic film to the transfer-receiving material and heating the assembly at a heating temperature of 60°C or more, and a light diffusion layer is formed on the transfer-receiving material by peeling off the support. Transfer may be performed at the heating temperature to transfer the organic film on the transfer-receiving material favorably in terms of transferring property without leaving the film regardless of whether the organic film is cured or not.

The heating temperature is preferably 80°C to 150°C, and more preferably 100°C to 140°C from the viewpoint of transferring property.

When the light-diffusing transfer material and the transfer-receiving material are bonded to each other and heated, the materials may also be pressurized at the same time. The pressure for pressurization is preferably 0.2 Pa to 20 Pa, and more preferably 0.5 Pa to 10 Pa.

For the bonding, it is possible to use a laminator, a vacuum laminator and the like which are publicly known in the related art, and in order to further enhance the productivity, an auto-cut laminator may also be used.

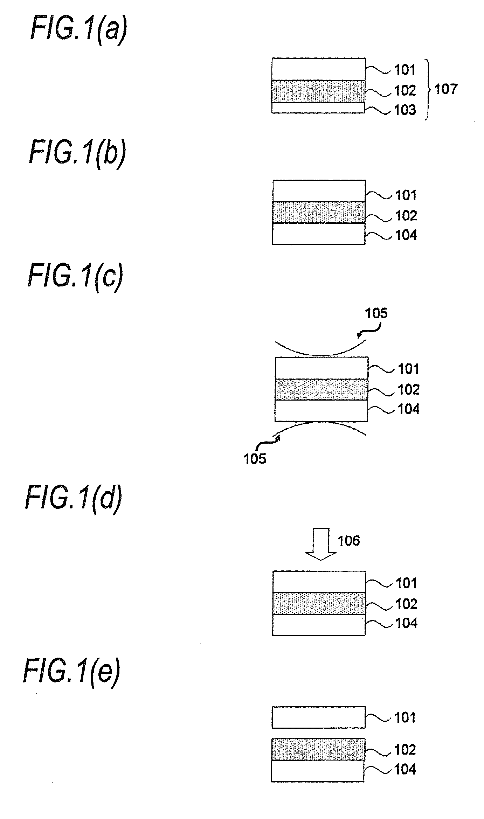

FIG. 1 schematically illustrates an example of a method for forming a light diffusion layer of the present invention.

In step (a), manufactured is a light-diffusing transfer material 107 in the form of a sheet according to the present invention, in which an organic film 102 is included on a support 101, and a cover film 103 is further formed on the organic film 102.

In the forming of the light diffusion layer, first, the cover film 103 is peeled off, and a surface of the organic film 102 of the light-diffusing transfer material 107 is bonded to a transfer-receiving material 104 (step (b)). Subsequently, the light-diffusing transfer material 107 and the transfer-receiving material 104 while being bonded to each other are heated and pressurized by a laminator 105 (step (c)). It is preferred that the heating temperature is set to 60°C or more and the pressurizing pressure is set to a pressure in the range. Thereafter, the organic film 102 is transferred on the transfer-receiving material 104 by peeling off the support 101 from the organic film 102, thereby forming a light diffusion layer (organic film 102) on the transfer-receiving material 104 (step (e)).

In the method for forming a light diffusion layer according to the present invention, it is preferred that the reactive curable resin or the curable compound is used as a resin of the organic film 102, and the organic film 102 is cured by irradiating an ionized radiation thereon (preferably photoirradiation). This is because the film strength is enhanced by curing.

Herein, examples of a preferred aspect of the curing include an aspect in which the organic film 102 is cured by irradiating ionized radiation 106 on the organic film 102 in the air while the light-diffusing transfer material 107 is bonded to the transfer-receiving material 104 (that is, before the support 101 is peeled off), as described in step (d) of FIG. 1. Since the organic film 102 may be sufficiently cured by irradiating ionized radiation thereon in the air, the atmosphere need not be controlled during the irradiation of ionized radiation, so that manufacturing facilities and the like may be conveniently operated. In the air in this case refers to an environment in which the oxygen concentration is 18% or more.

In this case, as the support 101, a support having an oxygen barrier property is preferred, and specifically, polyethylene terephthalate, polyethylene naphthalate, polyvinyl alcohol, polyvinyl chloride and the like are preferred.

Meanwhile, an aspect is also preferred, in which the support is peeled off from the organic film by transferring the organic film to the transfer-receiving material, and then the organic film is cured by irradiating ionized radiation on the organic film. The aspect is a preferred aspect when the degree of cure of the film is desired to be increased.

A light source for photoirradiation may be any light source having a wavelength in the vicinity of a wavelength (absorption wavelength) at which a curing agent or a photopolymerization initiator is reacted, which is used in combination with a reactive curable resin or a curable compound, and when the absorption wavelength is in the ultraviolet region, examples of the light source include ultrahigh pressure, high pressure, intermediate pressure and low pressure mercury lamp, a chemical lamp, a carbon arc lamp, a metal halide lamp, a xenon lamp, sunlight and the like. Various available laser light sources with a wavelength of 350 nm to 420 nm may be multi-beamed and irradiated. Furthermore, when the absorption wavelength is in the infrared region, examples of the light source include a halogen lamp, a xenon lamp and a high pressure sodium lamp, and various available laser light sources with a wavelength of 750 nm to 1,400 nm may be multi-beamed and irradiated.

The photoradical polymerization by phatoirradiation may be performed in the air or an inert gas. In the case of photoradical polymerization by phatairradiation, when the support is peeled off from the organic film, and then light is irradiated thereon, it is preferred to create an atmosphere in which the oxygen concentration is maintained as low as possible in order to shorten the induction period for polymerization of the radical polymerizable monomer or sufficiently increase the polymerization ratio. The oxygen concentration range is preferably 0 to 1,000 ppm, more preferably 0 to 800 ppm, and even more preferably 0 to 600 ppm.

The irradiation intensity of the ultraviolet light to be irradiated is preferably 0.1 mW/cm² to 100 mW/cm², and the amount of light irradiated on the surface of the coating film is preferably 100 mJ/cm² to 10,000 mJ/cm², more preferably 100 mJ/cm² to 5,000 mJ/cm², and particularly preferably 100 mJ/cm² to 1,000 mJ/cm², from the viewpoint of sufficiently curing the organic film without a change in color and the like.

Further, the temperature in the photoirradiation step is preferably 15°C to 70°C, more preferably 20°C to 60°C, and particularly preferably 25°C to 50°C, in efficiently performing curing.

### (Transfer-Receiving Material)

A transfer-receiving material used in the method for forming a light diffusion layer according to the present invention is not particularly limited, and may be selected according to the use for which the light diffusion layer is applied.

When a light diffusion layer is applied to an organic electroluminescent device, a substrate of the organic electroluminescent device to be described below may be used as a transfer-receiving material, and a transparent electrode or a laminate in which a transparent electrode, an organic electroluminescent layer and a reflective electrode are laminated in advance may be used as a transfer-receiving material, but it is preferred that a substrate is used as a transfer-receiving material.

### [Organic Electroluminescent Device and Method for Manufacturing Organic Electroluminescent Device]

The organic electroluminescent device of the present invention has a substrate, a light diffusion layer, a transparent electrode, an organic electroluminescent layer, and a reflective electrode in this order.

Herein, the light diffusion layer is formed by the method for forming a light diffusion layer of the present invention. In this case, it is preferred that the substrate is used as the transfer-receiving material, and the light diffusion layer is formed on the substrate. Since total reflection is strong at the interface of the transparent electrode with the substrate, the light extraction effect may be more efficiently obtained by disposing the light diffusion layer at this position.

A planarization layer may be formed between the light diffusion layer and the transparent electrode, but it is preferred that the planarization layer is not formed because a planarized light diffusion layer may be obtained by forming a light diffusion layer by the method for forming a light diffusion layer of the present invention.

In addition, a barrier layer may also be formed between the planarization layer or the light diffusion layer and the transparent electrode.

Furthermore, it is also preferred that the transparent electrode, the reflective electrode and the organic electroluminescent layer are sealed in a sealing case. It is also preferred that the light diffusion layer, or the planarization layer or the barrier layer is sealed in the sealing case, in addition to the transparent electrode, the reflective electrode and the organic electroluminescent layer.

### - Light Diffusion Layer -

The light diffusion layer is formed by the method for forming a light diffusion layer according to the present invention, and the organic film or a material obtained from the curing of the organic film becomes the light diffusion layer. That is, the light diffusion layer at least contains a binder composed of an organic material of the organic film or a material obtained from the curing of the organic material, a light-diffusing particle and a high refractive index inorganic filler.

The content ratio of the light-diffusing particle in the light diffusion layer is 25% by volume to 50% by volume, preferably 25% by volume to 40% by volume, and more preferably 30% by volume to 35% by volume. When the content ratio is less than 25% by volume, it is less likely that light incident to the light diffusion layer is scattered by the light-diffusing particle, and the capability of converting the light angle of the light diffusion layer is small, so that the light extraction efficiency may be decreased in some cases when the thickness of the light diffusion layer is not maintained at a sufficiently high level. In addition, increasing the thickness of the light diffusion layer leads to an increase in costs and the variation in thickness of the light diffusion layer becomes large, so that there is a concern that a variation in the scattering effect of the light emission in-plane occurs. Meanwhile, when the content ratio exceeds 50% by volume, the surface of the light diffusion layer is greatly roughened and voids are also produced therein, so that a physical strength of the light diffusion layer may be decreased in some cases.

The thickness T [µm] of the light diffusion layer and the content ratio N [% by volume] of the light-diffusing particle in the organic film satisfy the relationship T ≥ 150/N. Preferably, T ≥ 200/N, and more preferably, T ≥ 220/N. Furthermore, the upper limit is preferably T ≤ 400/N, and more preferably, T ≤ 370/N.

The thickness of the light diffusion layer is preferably 4 µm to 15 µm, more preferably 4 µm to 12 µm, and particularly preferably 4 µm to 9 µm. When the thickness falls within the range, an appropriate light dispersibility may be obtained, so that the thickness is suitable for enhancing the light extraction efficiency.

The average thickness of the light diffusion layer may be obtained, for example, by cutting a part of the light diffusion layer and measuring the part with a scanning type electron microscope (S-3400N, manufactured by Hitachi High Technologies Co.).

The refractive index of the binder in the light diffusion layer is preferably 1.7 to 2.2, more preferably 1.7 to 2.1, and even more preferably 1.7 to 2.0. When the refractive index of the binder falls within the range, the refractive index value is suitable for enhancing the light extraction efficiency of the organic electroluminescent device.

Further, it is preferred that the refractive index of the binder in the light diffusion layer is equivalent to or higher than the refractive index of the light emitting layer in the organic electroluminescent layer.

It is preferred that the light incident surface of the light diffusion layer is planarized, or has a planarization layer on the light incident surface of the light diffusion layer. Accordingly, even though the density of the light-diffusing particles is increased, the increase in backward scattering may be suppressed. In addition, sticking of the foreign matter is prevented by planarization.

Examples of a method for polarizing the light incident surface of the light diffusion layer without forming a planarization layer include a method for forming a light diffusion layer by transfer according to the method for forming the light diffusion layer of the present invention.

### - Planarization Layer -

As the planarization layer, a composition which does not include the light-diffusing particle in the light diffusion layer is preferred. The planarization layer may be formed by applying a coating composition including the resin and the high refractive index inorganic filler on the light diffusion layer, drying the coating composition, and curing the coating composition through irradiation of ionized radiation. The application and curing may be performed by the method described in the method for forming the light diffusion layer.

The average thickness of the planarization layer is particularly limited, and may be appropriately selected according to the purpose thereof, but is preferably 1 µm to 10 µm, more preferably 2 µm to 8 µm, and particularly preferably 3 µm to 6 µm from the viewpoint of planarization and enhancing the light extraction efficiency.

The combined average thickness of the light diffusion layer and the planarization layer is preferably 5 µm to 25 µm, more preferably 7 µm to 20 µm, and particularly preferably 8 µm to 15 µm from the viewpoint of planarization and enhancing the light extraction efficiency.

The refractive index of the planarization layer is preferably 1.7 to 2.2, more preferably 1.7 to 2.1, and even more preferably 1.7 to 2.0 from the viewpoint of the light extraction efficiency. It is preferred that the refractive index of the planarization layer is equivalent to or higher than the refractive index of the light diffusion layer.

### - Substrate -

The substrate is not particularly limited with respect to the shape, structure, size, material and the like, and may be appropriately selected according to the purpose thereof, and examples of the shape include a flat plate shape and the like, the structure may be a single-layer structure or a laminated structure, and the size may be appropriately selected according to the size of a light extraction member and the like.

A material for the substrate is not particularly limited, and may be appropriately selected according to the purpose thereof, and examples thereof include inorganic materials such as yttria-stabilized zirconia (YSZ) and glass (alkali-free glass, soda lime glass and the like), polyester resins such as polyethylene terephthalate (PET) and polyethylene naphthalate (PEN), polycarbonate, polyimide resin (PI), polyethylene, polyvinyl chloride, polyvinylidene chloride, polystyrene, styrene-acrylonitrile copolymers and the like. The materials may be used either alone or in combination of two or more thereof. Among them, a polyester resin is preferred, and polyethylene terephthalate (PET) and polyethylene naphthalate (PEN) are particularly preferred from the viewpoint of application suitability in a roll.

It is preferred that the surface of the substrate is subjected to surface activation treatment in order to enhance adhesion with the light diffusion layer formed thereon. Examples of the surface activation treatment include a glow discharge treatment, a corona discharge treatment and the like.

As the substrate, a substrate which is appropriately synthesized may be used, and a commercially available product may be used.

The thickness of the substrate is particularly limited, and may be appropriately selected according to the purpose thereof, and is preferably 10 µm or more, and more preferably 50 µm or more.

The refractive index of the substrate is preferably 1.3 to 1.8, more preferably 1.4 to 1.7, and even more preferably 1.4 to 1.6 from the viewpoint of enhancing the light extraction efficiency by reducing the difference in refractive indices between the refractive index of the substrate and the refractive index of the light diffusion layer or the air (light emitting side).

### - Organic Electroluminescent Layer -

The organic electroluminescent layer at least has a light emitting layer. Examples of a functional layer other than the light emitting layer include each layer such as a hole transporting layer, an electron transporting layer, a hole blocking layer, an electron blocking layer, a hole injection layer and an electron injection layer.

The organic electroluminescent layer preferably has a hole transporting layer between an anode and a light emitting layer, and preferably has an electron transporting layer between a cathode and a light emitting layer. In addition, a hole injection layer may be formed between a hole transporting layer and an anode, and an electron injection layer may be formed between an electron transporting layer and a cathode.

Furthermore, a hole transportable intermediate layer (electron blocking layer) may be formed between the light emitting layer and the hole transporting layer, and an electron transportable intermediate layer (hole blocking layer) may be formed between the light emitting layer and the electron transporting layer. Each functional layer may be divided into a plurality of secondary layers.

These functional layers including the light emitting layer may be suitably formed with any of a dry film-forming method such as a vapor deposition method and a sputtering method, a wet application system, a transfer method, a printing method, and an inkjet system.

### -- Light Emitting Layer --

The light emitting layer is a layer having functions, at the time of applying an electric field, of accepting holes from the anode, the hole injection layer or the hole transporting layer and accepting an electron from the cathode, the electron injection layer or the electron transporting layer to provide a site of recombination of the hole and the electron, thereby achieving light emission.

The light emitting layer includes a light emitting material. The light emitting layer may be composed of only a light emitting layer and even a mixed layer of a host material and a light emitting material (in the latter case, the light emitting material is referred to as the "light emitting dopant" or the "dopant" in some cases). The light emitting layer may be a fluorescent light emitting material or a phosphorescent light emitting material, and two or more thereof may be mixed. The host material is preferably a charge transporting material. The host material may be made of a single kind or two or more kinds thereof. Further, the light emitting layer may include a material which does not have charge transporting properties and does not emit light.

The thickness of the light emitting layer is not particularly limited, and may be appropriately selected according to the purpose thereof, and is preferably 2 nm to 500 nm, and from the viewpoint of external quantum efficiency, more preferably 3 nm to 200 nm and even more preferably 5 nm to 100 nm. In addition, the light emitting layer may be made of a single layer or two or more layers, and each layer may emit light with different light emitting colors.

### --- Light Emitting Material ---

As the light emitting material, any one of the phosphorescent light emitting material or fluorescent light emitting material may be suitably used.

The light emitting material is preferably a dopant in which a difference (ΔIp) in the ionization potential and a difference (ΔEa) in the electron affinity between the light emitting material and the host compound satisfy the relationship of 1.2 eV > ΔIp > 0.2 eV and/or 1.2 eV > ΔEa > 0.2 eV from the viewpoint of driving durability.

The light emitting material in the light emitting layer is contained in an amount of 0.1% by mass to 50% by mass based on the total mass of the compounds which generally form the light emitting layer in the light emitting layer, preferably 1% by mass to 50% by mass from the viewpoint of durability and external quantum efficiency, and more preferably 2% by mass to 50% by mass.

<Phosphorescent Light Emitting Material>

Examples of the phosphorescent light emitting material include a complex which generally includes a transition metal atom or a lanthanoid atom.

The transition metal atom is not particularly limited, and may be appropriately selected according to the purpose thereof, and examples thereof include ruthenium, rhodium, palladium, tungsten, rhenium, osmium, iridium, gold, silver, copper and platinum, rhenium, iridium and platinum is more preferred, and iridium and platinum is even more preferred.

Examples of the ligand of the complex include the ligands and the like described in G. Wilkinson et al., Comprehensive Coordination Chemistry published by Pergamon Press in 1987, H. Yersin, "Photochemistry and Photophysics of Coordination Compounds" published by Springer-Verlag in 1987, Akio Yamamoto, "Organic Metal Chemistry - Foundation and Application -" published by SHOKABO PUBLISHING Co., Ltd. in 1982, and the like.

The complex may have one transition metal atom in the compound or may be a so-called binuclear complex having two or more transition metal atoms. Different kinds of metal atoms may be contained at the same time.

Among them, examples of the phosphorescent light emitting material include the phosphorescent light emitting compounds and the like described in each patent document such as US6303238B1, US6097147, WO00/57676, WO00/70655, WO01/08230, WO01/39234A2, WO01/41512A1, WO02/02714A2, WO02/15645A1, WO02/44189A1, WO05/19373A2, WO2004/108857A1, WO2005/042444A2, WO2005/042550A1, Japanese Patent Application Laid-Open Nos. 2001-247859, 2002-302671, 2002-117978, 2003-133074, 2002-235076, 2003-123982 and 2002-170684, EP1211257, Japanese Patent Application Laid-Open Nos. 2002-226495, 2002-234894, 2001-247859, 2001-298470, 2002-173674, 2002-203678, 2002-203679, 2004-357791, 2006-93542, 2006-261623, 2006-256999, 2007-19462, 2007-84635 and 2007-96259. Among them, Ir complexes, Pt complexes, Cu complexes, Re complexes, W complexes, Rh complexes, Ru complexes, Pd complexes, Os complexes, Eu complexes, Tb complexes, Gd complexes, Dy complexes, and Ce complexes are preferred, Ir complexes, Pt complexes or Re complexes are more preferred, Ir complexes, Pt complexes or Re complexes each including at least one coordination mode of metal-carbon bonds, metal-nitrogen bonds, metal-oxygen bonds and metal-sulfur bonds are even more preferred, and Ir complexes, Pt complexes or Re complexes each including a tri-dentate or higher poly-dentate ligand are particularly preferred from the viewpoint of light-emission efficiency, driving durability, chromaticity and the like.

Specific examples of the phosphorescent light emitting material include the following compounds, but are not limited thereto.

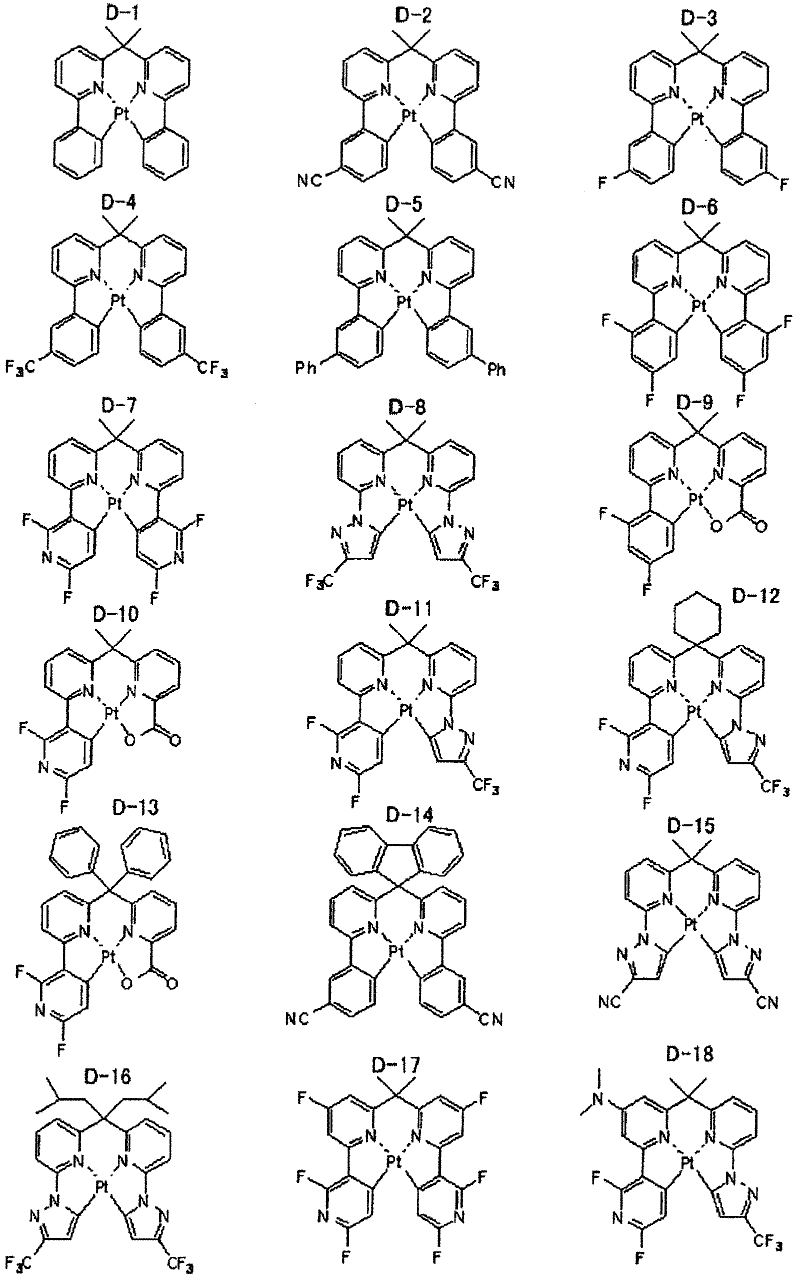

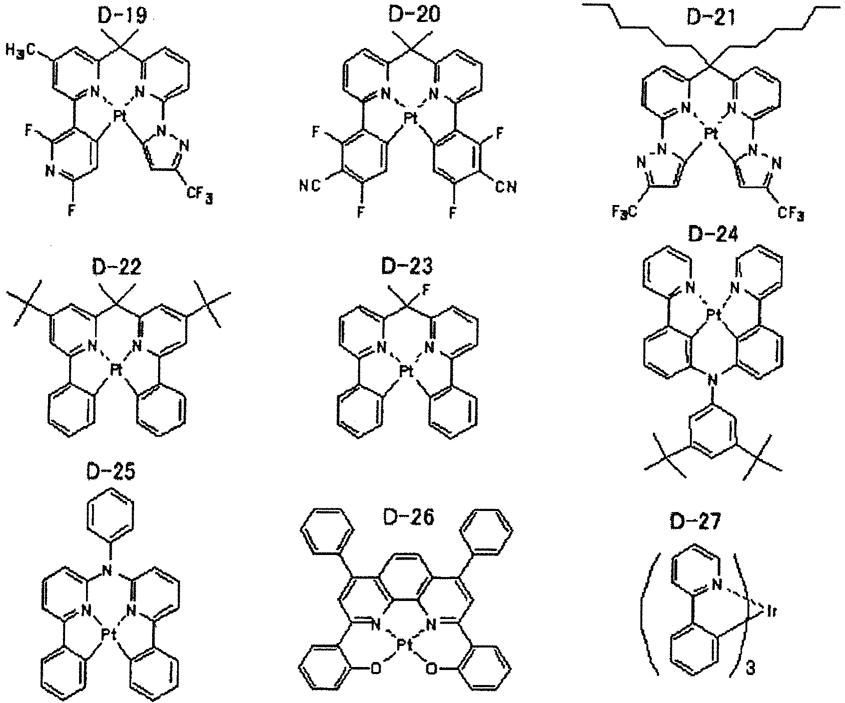

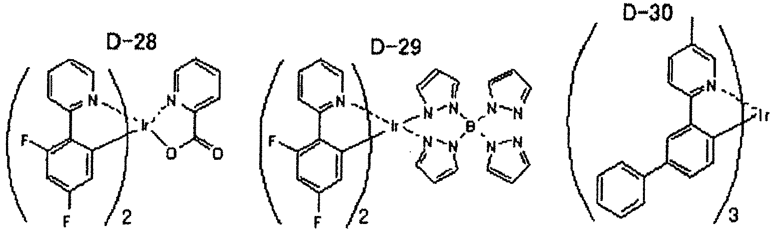

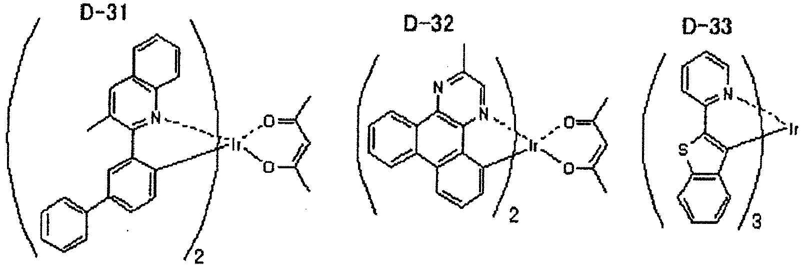

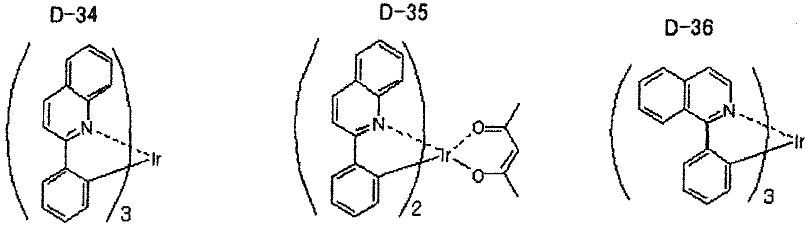

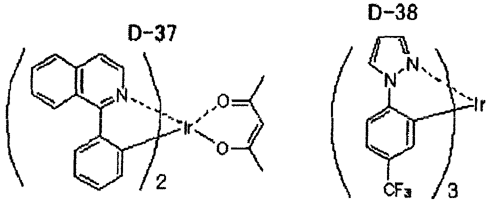

### <Fluorescent Light Emitting Material>

The fluorescence light emitting material is not particularly limited, and may be appropriately selected according to the purpose thereof, and examples thereof include benzoxazole, benzoimidazole, benzothiazole, styrylbenzene, polyphenyl, diphenylbutadiene, tetraphenylbutadiene, naphthalimide, coumarin, pyran, perinone, oxadiazole, aldazine, pyridine, cyclopentadiene, bis-styrylanthracene, quinacridone, pyrrolopyridine, thiadiazolopyridine, cyclopentadiene, styrylamine, aromatic dimethylidine compounds, condensed polycyclic aromatic compounds (anthracene, phenanthroline, pyrene, perylene, rubrene or pentacene and the like), various metal complexes represented by metal complexes of 8-quinolynol, pyromethene complexes and rare-earth complexes, polymer compounds such as polythiophene, polyphenylene and polyphenylenevinylene, organic silanes or derivatives thereof and the like.

### --- Host Material ---

As the host material, it is possible to use hole transporting host materials excellent in hole transporting property (which may be referred to as a hole transporting host in some cases) and electron transporting host compounds excellent in electron transporting property (which may be referred to as an electron transporting host in some cases).

### <Hole Transporting Host Material>

Examples of the hole transporting host material include the following materials. That is, examples thereof include pyrrole, indole, carbazole, azaindole, azacarbazole, triazole, oxazole, oxadiazole, pyrazole, imidazole, thiophene, polyarylalkane, pyrazoline, pyrazolone, phenylenediamine, arylamine, amino-substituted chalcone, styrylanthracene, fluorenone, hydrazone, stilbene, silazane, aromatic tertiary amine compounds, styrylamine compounds, aromatic dimethylidine-based compounds, porphyrin-based compounds, polysilane-based compounds, poly(N-vinylcarbazole), aniline-based copolymers, conductive polymer oligomers such as thiophene oligomers and polythiophenes, organic silanes, carbon films or derivatives thereof, and the like.

Among them, indole derivatives, carbazole derivatives, aromatic tertiary amine compounds, thiophene derivatives and compounds including a carbazole group in the molecule are preferred, and compounds including a t-butyl-substituted carbazole group are more preferred.

### <Electron Transporting Host Material>

Examples of the electron transporting host material include pyridine, pyrimidine, triazine, imidazole, pyrazole, triazole, oxazole, oxadiazole, fluorenone, anthraquinonedimethane, anthrone, diphenylquinone, thiopyrandioxide, carbodiimide, fluorenylidenemethane, distyrylpyrazine, fluorine-substituted aromatic compounds, heterocyclic tetracarboxylic anhydrides such as naphthalene and perylene, phthalocyanine, derivatives thereof (which may form a condensed ring with another ring) and various metal complexes represented by metal complexes of 8-quinolynol derivatives or metal phthalocyanine, and metal complexes having benzoxazole or benzothiazole as a ligand, and the like. Among them, metal complex compounds are preferred in terms of durability, and more preferred are metal complexes including a ligand, which are coordinated with the metal and have at least one nitrogen atom, oxygen atom, or sulfur atom. Examples of the metal complex electron transporting host include the compounds described in Japanese Patent Application Laid-Open Nos. 2002-235076, 2004-214179, 2004-221062, 2004-221065, 2004-221068 and 2004-327313, and the like.

Specific examples of the hole transporting host material and the electron transporting host material include the following compounds, but are not limited thereto.

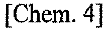

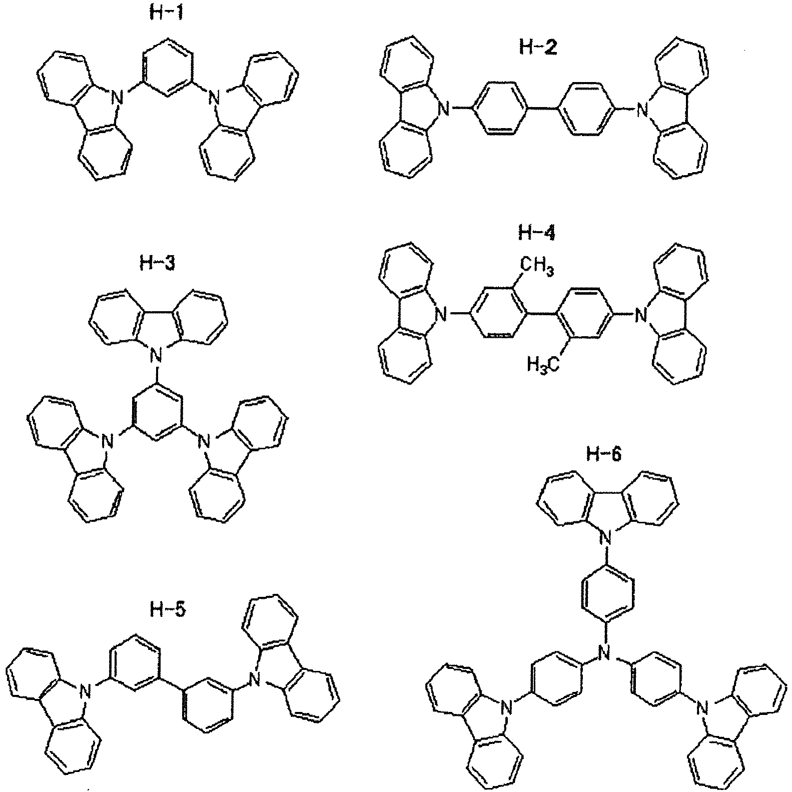

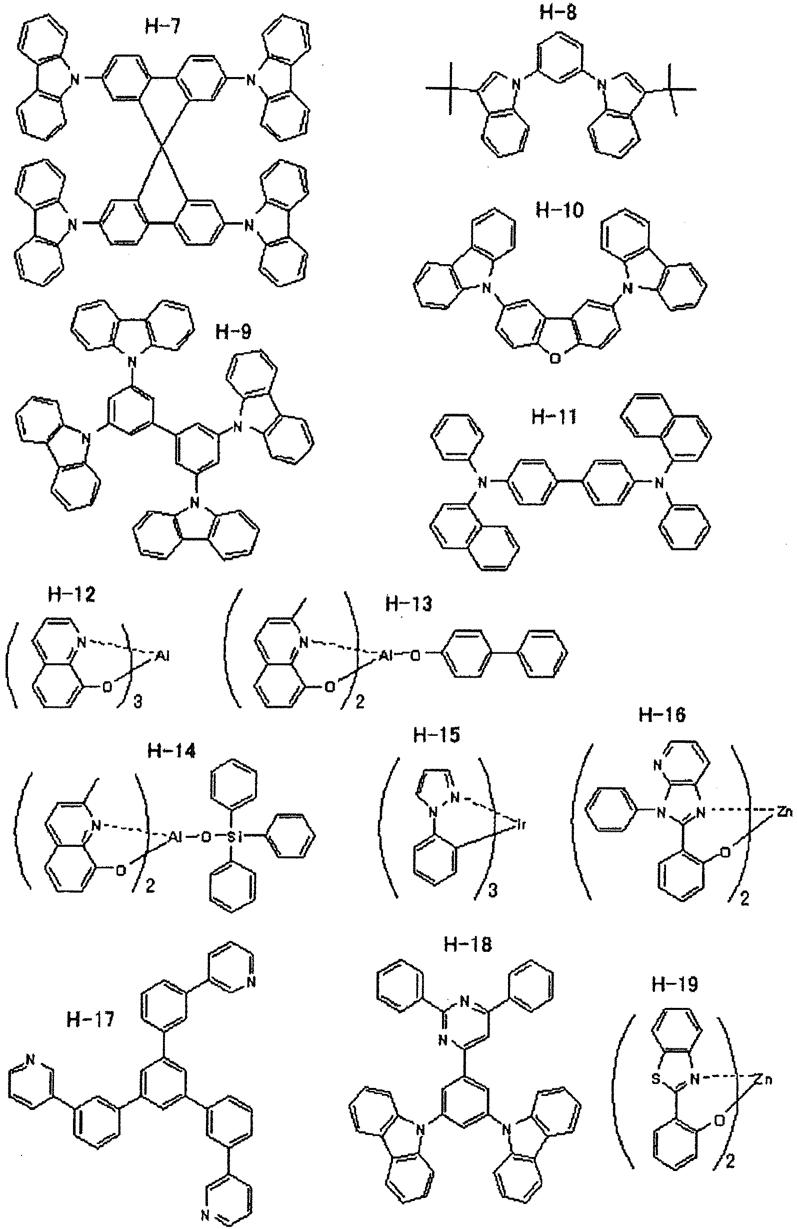

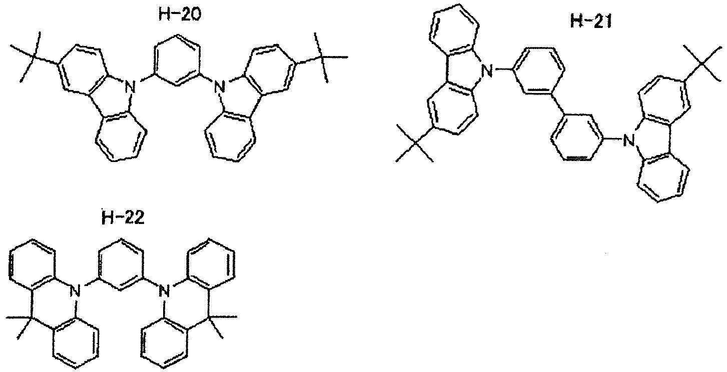

### -- Hole Injection Layer and Hole Transporting Layer --

The hole injection layer or the hole transporting layer is a layer having a function of accepting holes from the anode or a layer on the anode side to transport the holes into the cathode side. A hole injection material or a hole transporting material used in these layers may be a low molecular weight compound or a polymer compound. Specifically, preferred is a layer containing a pyrrole derivative, a carbazole derivative, a triazole derivative, an oxazole derivative, a oxadiazole derivative, an imidazole derivative, a polyarylalkane derivative, a pyrazoline derivative, a pyrazolone derivative, a phenylenediamine derivative, an arylamine derivative, an amino-substituted chalcone derivative, a styrylanthracene derivative, a fluorenone derivative, a hydrazone derivative, a stilbene derivative, a silazane derivative, an aromatic tertiary amine compound, a styrylamine compound, an aromatic dimethylidine compound, a phthalocyanine-based compound, a porphyrin-based compound, a thiophene derivative, an organic silane derivative, carbon and the like.

The hole injection layer or the hole transporting layer may contain an electron-accepting dopant. As the electron-accepting dopant introduced into the hole injection layer or the hole transporting layer, an inorganic compound or an organic compound may be used as long as the dopant has electron accepting property and a property of oxidizing an organic compound.

Specific examples of the inorganic compound include metal halides such as ferric chloride, aluminum chloride, gallium chloride, indium chloride and antimony pentachloride, metal oxides such as vanadium pentaoxide and molybdenum trioxide, and the like. In the case of the organic compound, a compound having a nitro group, a halogen, a cyano group, a trifluoromethyl group and the like as the substituent, a quinone-based compound, an acid anhydride-based compound, and fullerene may be suitably used.

These electron accepting dopants may be used either alone, or two or more thereof may be used. The amount of the electron accepting dopant used varies according to the kind of material, but is preferably 0.01% by mass to 50% by mass, more preferably 0.05% by mass to 40% by mass, and particularly preferably 0.1% by mass to 30% by mass, based on the hole transporting layer material.

The hole injection layer or the hole transporting layer may have a single layer structure composed of one or two or more kinds of the above-described materials or may have a multilayered structure composed of a plurality of layers of the same or different compositions.

### -- Electron Injection Layer and Electron Transporting Layer --

The electron injection layer or the hole transporting layer is a layer having a function of accepting electrons from the cathode or a layer on the cathode side to transport the electrons into the anode side. An electron injection material or an electron transporting material used in these layers may be a low molecular weight compound or a polymer compound.

Specifically, preferred is a layer containing a pyridine derivative, a quinoline derivative, a pyrimidine derivative, a pyrazine derivative, a phthalazine derivative, a phenanthroline derivative, a triazine derivative, a triazole derivative, an oxazole derivative, an oxadiazole derivative, an imidazole derivative, a fluorenone derivative, an anthraquinodimethane derivative, an anthrone derivative, a diphenylquinone derivative, a thiopyrandioxide derivative, a carbodiimide derivative, a fluorenylidenemethane derivative, a distyrylpyrazine derivative, an aromatic cyclic tetracarboxylic anhydride of naphthalene, perylene and the like, a phthalocyanine derivative, various metal complexes represented by metal complexes of an 8-quinolinol derivative or metal complexes containing, as a ligand, metal phthalocyanine, benzoxazole or benzothiazole, an organic silane derivative represented by silole, or the like.

The electron injection layer or the electron transporting layer may contain an electron-donating dopant. As the electron-donating dopant which is introduced into the electron injection layer or the electron transporting layer, the dopant may be electron-donating and have a property of reducing an organic compound, and alkali metals such as Li, alkaline earth metals such as Mg, transition metals including rare earth metals, reducing organic compounds and the like are appropriately used. In particular, a metal having a work function of 4.2 eV or less may be appropriately used as the metal, and specific examples thereof include Li, Na, K, Be, Mg, Ca, Sr, Ba, Y, Cs, La, Sm, Gd, Yb and the like. Furthermore, examples of the reducing organic compound include nitrogen-containing compounds, sulfur-containing compounds, phosphorus-containing compounds and the like.

These electron-donating dopants may be used either alone or in combination of two or more thereof. The amount of the electron-donating dopant used varies according to the kind of material, but is preferably 0.1% by mass to 99% by mass, more preferably 1.0% by mass to 80% by mass, and particularly preferably 2.0% by mass to 70% by mass based on the electron transporting layer material.

The electron injection layer or the electron transporting layer may have a single layer structure composed of one or two or more kinds of the above-described materials or may have a multilayered structure composed of a plurality of layers of the same or different compositions.

### -- Hole Blocking layer and Electron Blocking Layer --

The hole blocking layer is a layer having a function of preventing holes transported from the anode side to the light emitting layer from going through to the cathode side, and is typically formed as an organic compound layer adjacent to the light emitting layer at the cathode side.

Meanwhile, the electron blocking layer is a layer having a function of preventing electrons transported from the cathode side to the light emitting layer from going through to the anode side, and is typically formed as an organic compound layer adjacent to the light emitting layer at the anode side.

Examples of a compound constituting the hole blocking layer include aluminum complexes such as BAlq, triazole derivatives, phenanthroline derivatives such as BCP, and the like. As an example of a compound constituting the electron blocking layer, for example, those exemplified as the above-described hole transporting material may be used.

The thickness of the hole blocking layer and the electron blocking layer is preferably 1 nm to 500 nm, more preferably 5 nm to 200 nm, and even more preferably 10 nm to 100 nm. Further, the hole blocking layer and the electron blocking layer may have a single layer structure composed of one or two or more kinds of the above-described materials or may have a multilayered structure composed of a plurality of layers of the same or different compositions.

### -- Electrode --

The organic electroluminescent element includes a transparent electrode and a reflective electrode, that is, an anode and a cathode. In view of the properties of the organic electroluminescent element, at least one electrode of the anode and the cathode is preferably transparent.

Typically, it may suffice that the anode has a function as an electrode for supplying holes to the organic compound layer, and it may suffice that the cathode has a function as an electrode for injecting electrons to the organic compound layer. The shape, structure, size and the like thereof are not particularly limited and can be appropriately selected from publicly known electrode materials in accordance with the use and purpose of the light emitting element. Examples of the material constituting the electrode suitably include metals, alloys, metal oxides, conductive compounds or mixtures thereof, and the like.

The electrode is not particularly limited, and may be appropriately selected according to the purpose thereof, but it is preferred that the anode and the cathode thereof are composed of the reflective metal and the semitransparent metal as the semitransparent member.

Specific examples of the material constituting the anode include conductive metal oxide such as tin oxide (ATO, FTO) doped with antimony or fluorine, tin oxide, zinc oxide, indium oxide, indium tin oxide (ITO) and indium zinc oxide (IZO), the metal such as gold, silver, chromium and nickel, mixtures or laminates of the metals and the conductive metal oxides, an inorganic conductive material such as copper iodide and copper sulfide, an organic conductive compound such as polyaniline, polythiophene, and polypyrrole, laminates of the materials and ITO, and the like. Among them, preferred are conductive metal oxides, and ITO is particularly preferred in view of productivity, high conductivity, transparency and the like.

Examples of the material constituting the cathode includes alkali metals (for example, Li, Na, K, Cs and the like), alkaline earth metals (for example, Mg, Ca and the like), gold, silver, lead, aluminum, sodium-potassium alloys, lithium-aluminum alloys, magnesium-silver alloys, indium, rare earth metals such as ytterbium, and the like. These materials may be used alone, but two or more thereof may be suitably used in combination from the viewpoint of making the stability and the electron injection property compatible. Among them, alkali metals or alkaline earth metals are preferred in view of the electron injection property, and materials mainly including aluminum are preferred in view of excellent storage stability. Materials mainly including aluminum refer to aluminum per se, alloys of aluminum and 0.01% by mass to 10% by mass of alkali metals or alkaline earth metals, or mixtures thereof (for example, lithium-aluminum alloys, magnesium-aluminum alloys and the like).

The method for forming the electrode is not particularly limited, and the electrode may formed in accordance with publicly known methods. For example, the electrode may be formed on the substrate in accordance with a method appropriately selected from wetting methods such as a printing method and a coating method, physical methods such as a vacuum vapor deposition method, a sputtering method and an ion plating method, and chemical methods such as CVD or a plasma CVD method in consideration of the suitability with the material constituting the cathode. For example, when ITO is selected as a material for the anode, the ITO may be formed in accordance with a direct current or high-frequency sputtering method, a vacuum vapor deposition method, an ion plating method and the like. When metals or the like are selected as a material for the cathode, the metal may be formed in accordance with a sputtering method and the like by sputtering one or two or more of the metals simultaneously or successively.

Meanwhile, when patterning is performed upon forming the electrode, the patterning may be performed by a chemical etching such as photolithography, or a physical etching by laser and the like, and the patterning may be performed by vacuum vapor deposition or sputtering and the like while stacking masks or by a lift-off method or a printing method.

### - Barrier Layer -

The barrier layer is not particularly limited, and may be appropriately selected according to the purpose thereof, and may be a single organic layer composed of an organic material or a single inorganic layer composed of an inorganic material, but may have a multilayered structure in which an organic layer composed of an organic material and an inorganic layer composed of an inorganic material are laminated.

Examples of the inorganic material include SiNx, SiON, SiO₂, Al₂O₃, TiO₂ and the like.

Examples of the organic material include silicone-based polymers, epoxy-based polymers, acrylic polymers, urethane-based polymers and the like.

A method for forming the barrier layer is not particularly limited, and may be appropriately selected according to the material, and examples thereof include a coating method, a CVD method, a vacuum vapor deposition method, a sputtering method and the like.

The refractive index of the barrier layer (an average refractive index in the case of a multilayered structure) is preferably 1.7 or more, and more preferably 1.8 to 2.2. When the refractive index of the barrier layer is less than 1.7, total reflection of light from the organic electroluminescent layer is increased at the interface of the transparent electrode and the barrier layer, so that the light extraction efficiency may be reduced in some cases.

For optical properties of the barrier layer, light transmittance is preferably 80% or more, more preferably 85% or more, and even more preferably 90% or more.

The average thickness of the barrier layer is not particularly limited, and may be appropriately selected according to the purpose thereof, and is preferably 0.1 µm to 10 µm, more preferably 0.1 µm to 5 µm, and even more preferably 0.2 µm to 3 µm. When the average thickness of the barrier layer is less than 0.1 µm, a sealing function of preventing transmittance of oxygen and moisture in the air may be insufficient in some cases, and when the average thickness of the barrier exceeds 10 µm, light transmittance is reduced, so that transparency is impaired, or when an inorganic material is used in a single layer, barrier properties, such as cracks due to a difference in stress and peeling-off with adjacent layers, may be impaired in some cases.

### - Sealing case -

The sealing case is not particularly limited as long as the case has a size, a shape, a structure and the like, which may seal a laminate composed of the transparent electrode, the reflective electrode, the organic electroluminescent layer, the planarization layer and the light diffusion layer, and may be appropriately selected according to the purpose thereof.

A moisture absorbent or an inert liquid may seal the space between laminates composed of the sealing case, the transparent electrode, the reflective electrode, the organic electroluminescent layer, the planarization layer and the light diffusion layer.

The moisture absorbent is not particularly limited, and may be appropriately selected according to the purpose thereof, and examples thereof include barium oxide, sodium oxide, potassium oxide, calcium oxide, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieves, zeolites, magnesium oxide and the like.

The inert liquid is not particularly limited, and may be appropriately selected according to the purpose thereof, and examples thereof include paraffins, fluid paraffins; fluorine-based solvents such as perfluoroalkanes, perfluoroamines and perfluoroether; chlorine-based solvents, silicone oils and the like.

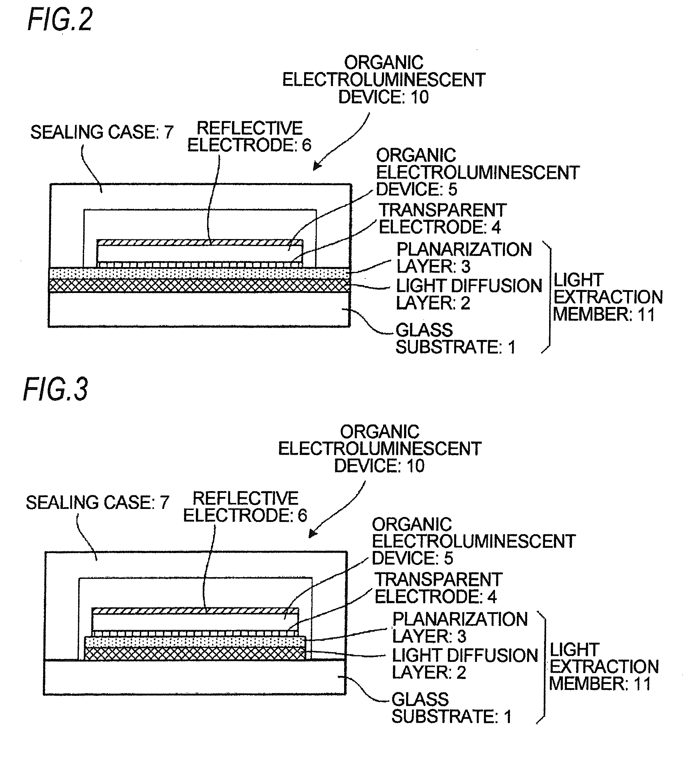

Herein, FIG. 2 is a schematic view illustrating an example of the organic electroluminescent device of the present invention. An organic electroluminescent device 10 in FIG. 2 has a transparent electrode 4, an electroluminescent layer 5 and a reflective electrode 6 on a planarization layer 3 of a light extraction member 11 having a light diffusion layer 2 and the planarization layer 3 on a glass substrate 1, in which the transparent electrode 4, the organic electroluminescent layer 5 and the reflective electrode 6 is sealed with a sealing case.

Further, as illustrated in FIG. 3, the light diffusion layer 2, the planarization layer 3, the transparent electrode 4, the organic electroluminescent layer 5 and the reflective electrode 6 are sealed in the sealing case 7, so that stability over time may be enhanced.

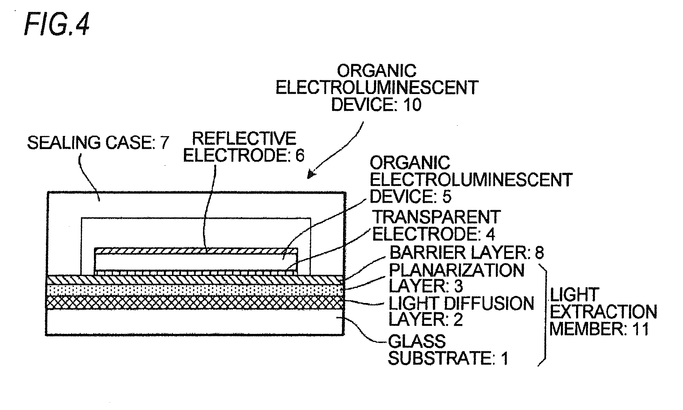

In addition, as illustrated in FIG. 4, stability over time may be enhanced by forming a barrier layer 8 on the planarization layer 3 of the light extraction member 11 in FIG. 2.

The organic electroluminescent device may be configured as a device which may display a full color image.

As a method for manufacturing the organic electroluminescent device with a full color-type device, there are known, for example, as described in "Monthly Display", an issue of September 2000, pp. 33 to 37, a tricolor light emission method which arranges layer structures each emitting light corresponding to three primary colors (blue color (B), green color (G), and red color (R)) on a substrate, respectively, a white color method which divides white light emitted by a layer structure for white color emission into three primary colors through a color filter layer, a color conversion method which converts a blue light emitted by a layer structure for blue light emission into red color (R) and green color (G) through a fluorescent colorant layer, and the like.

In this case, it is preferred that laser power and thickness are appropriately adjusted for each pixel of blue color (B), green color (G) and red color (R).

Further, by combining and using a plurality of layer structures of different light emission colors obtained by the methods described above, a planar fluorescent light source of a desired emission color may be obtained. For example, as the light source, there are a white light emitting source obtained by combining blue and yellow light emitting elements, a white light emitting source obtained by combining blue (B), green (G) and red (R) color light emitting elements, and the like.

The organic electroluminescent device may be suitably used in various fields including, for example, a lighting device, a computer, an on-vehicle display, an outdoor display, a household appliance, a business device, a home electronics device, a transportation relationship indicator, a clock display, a calendar display, a luminescent screen, an audio device and the like.

### Examples

Hereinafter, Examples of the present invention will be described, but the present invention is not limited to the Examples.

In the Examples and the Comparative Examples to be described below, the thickness of an organic film and a light diffusion layer was measured as follows.

### <Thickness of Organic Film and Light Diffusion Layer>

The thickness of the light diffusion layer was obtained by cutting a part of the organic film and the light diffusion layer and measuring the part with a scanning type electron microscope (S-3400N, manufactured by Hitachi High Technologies Corporation).

### (Example 1)

### <Manufacture of Light-Diffusing Transfer Sheet 1>

A high refractive index resin was obtained by mixing 11.2 g of a resin material (acrylate compound "Ogsol EA-200" (manufactured by Osaka Gas Chemicals Co., Ltd.)) and 40 g of a high refractive index inorganic filler (TiO₂ liquid dispersion HTD-760(TAYCA Corporation) with 42 g of toluene, stirring and dissolving the resulting mixture by a roller mixer or a stirrer, and dispersing TiO₂ therein by ultrasonic wave (Sonifer).

14.8 g of a light-diffusing particle (a crosslinked acrylic particle having an average diameter of 1.5 µm, refractive index 1.49, and material name "EX-150") was added to 93 g of the high refractive index resin obtained while being stirred by the stirrer, the light-diffusing particle was sufficiently dispersed in the high refractive index resin by ultrasonic wave, and the resulting mixture was further well stirred by the stirrer. Subsequently, a coating composition for forming a resin film, in which the content ratio of the light-diffusing particle in the resin film was 30% by volume, was obtained by adding a polymerization initiator (IRGACURE819, manufactured by BASF Corp.) in an amount of 2% by mass based on the resin in an environment where light having a wavelength of 450 nm or less was cut, and sufficiently stirring the resulting mixture.

Subsequently, a resin film (organic film) having a thickness of 5 µm was formed by applying the coating composition for forming a resin film on a support (thickness: 0.75 mm, 200 mm angle) composed of a PET film subjected to surface treatment with a fluorine-based silane coupling agent (OPTOOL DSX (Daikin Industries, Ltd.)) and drying the coating composition. Light-Diffusing Transfer Sheet 1 is obtained by adhering to a cover film (formed of polypropylene) on the resin film.

### <Transfer to Substrate>

After a glass substrate (manufactured by Corning Inc., Eagle XG, and refractive index 1.51) was put into a washing container to perform an ultrasonic wave washing in a neutral detergent, an ultrasonic wave washing was performed in pure water, and the glass substrate is heated and dried at 120°C for 120 minutes.

The cover film was peeled off from Light-Diffusing Transfer Sheet 1 to adhere the surface at the organic film side to the surface of the glass substrate, and bonding was performed by heating and pressurizing the adherend at a temperature of 120°C and a pressure of 1 MPa using a laminator. Subsequently, the organic film was cured by irradiating ultraviolet light from the PET film side of Light-Diffusing Transfer Sheet 1 in the air while the light-diffusing transfer sheet was bonded to the glass substrate. Thereafter, a light diffusion layer, in which the organic film was uniformly transferred on the glass substrate, was obtained by peeling off the PET film of Light-Diffusing Transfer Sheet 1.

The transfer yield of the light diffusion layer was 97%. Herein, the transfer yield was a ratio (%) of the number of sheets in which the organic film was uniformly transferred without leaving a film when the light diffusion layer was formed by preparing 100 sheets with the light-diffusing transfer sheet 100 mm angle, and transferring the organic film on the glass substrate by the above-described method.

### <Manufacture of Organic Electroluminescent Device 1>

Subsequently, a film was formed on the light diffusion layer by a sputtering method such that the indium tin oxide (ITO) has a thickness of 100 nm.

Subsequently, a hole injection layer, in which 99.7% by mass of 4,4'4"-tris(N,N-(2-naphthyl)-phenylamino)triphenylamine (2-TNATA) represented by the following structural formula was doped with 0.3% by mass of F4-TCNQ represented by the following structural formula, was co-deposited on the ITO to have a thickness of 250 nm.

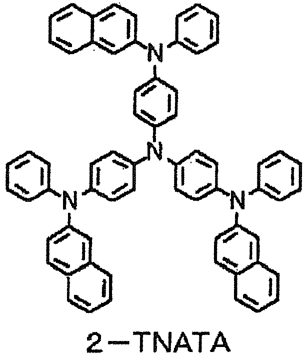

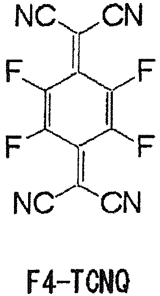

Subsequently, α-NPD(bis[N-(1-naphthyl)-N-phenyl]benzidine) as a hole transporting layer was formed to have the thickness of 10 nm on the hole injection layer by a vacuum vapor deposition method.

Subsequently, a second hole transporting layer having a thickness of 3 nm was formed to have a thickness of 3 nm on the hole transporting layer by vacuum depositing an organic material A represented by the following structural formula.

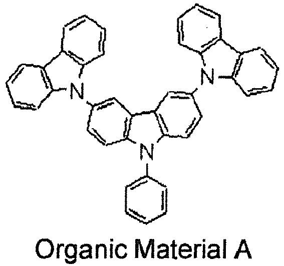

Subsequently, a white light emitting layer, in which 60% by mass of mCP (1,3-Bis(carbazol-9-yl)benzene) represented by the following structural formula as a host material was doped with 40% by mass of a light emitting material A represented by the following structural formula as a phosphorescent light emitting material, was vacuum vapor deposited in a thickness of 30 nm on the second hole transporting layer.

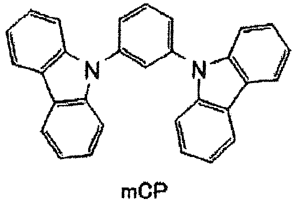

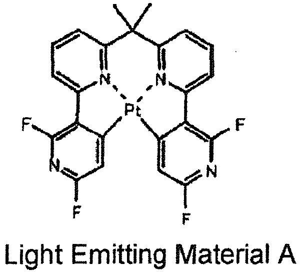

Subsequently, BAlq (bis-(2-methyl-8-quinolinolato)-4-(phenyl-phenolate)-aluminium(III)) represented by the following structural formula as an electron transporting layer was vacuum vapor deposited on the light emitting layer to have a thickness of 39 nm.

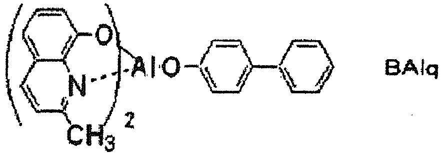

Subsequently, BCP (2,9-dimethyl-4,7-diphenyl-1,10-phenanthroline) represented by the following structural formula as an electron injection layer was vapor deposited on the electron transporting layer to have a thickness of 1 nm.

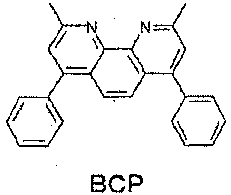

Subsequently, a laminate was manufactured by vapor depositing LiF as a buffer layer on the electron injection layer so as to have a thickness of 1 nm and vapor depositing aluminum as an electrode layer on the buffer layer so as to have a thickness of 100 nm.

Subsequently, the manufactured laminate was adhered to a drying agent under a nitrogen gas atmosphere, and the organic layer side of the substrate was sealed with a sealing case in which a sealant is coated on a surface on which the substrate is provided.

As described above, Organic Electroluminescent Device 1 was manufactured. Further, Organic Electroluminescent Device 1 for reference without a light diffusion layer was manufactured in the same manner as described above, except that the light diffusion layer is not formed.

### <Calculation of Light Extraction Efficiency>

For each external quantum efficiency of Organic Electroluminescent Device 1 and Organic Electroluminescent Device 1 for reference, the light extraction efficiency of Organic Electroluminescent Device 1 was calculated from the following formula by applying a direct current constant current (0.2 mA) to each organic electroluminescent device to emit light using an external quantum efficiency measuring apparatus "C9920-12" manufactured by Hamamatsu Photonics K.K. and measuring the external quantum efficiency.

### Light Extraction Efficiency (Times) =

### (External quantum efficiency of the organic electroluminescent device / External quantum efficiency of the organic electroluminescent device for reference)

The light extraction efficiency of the organic electroluminescent device was 1.65 times.

### (Example 2)

In the manufacture of Light-Diffusing Transfer Sheet 1 of Example 1, a Light-Diffusing Transfer Sheet 2 was manufactured in the same manner as in Light-Diffusing Transfer Sheet 1, except that the film thickness of the organic film was set to 8 µm. A light diffusion layer by transfer was formed under the same condition as in Example 1, and as a result, the transfer yield of the light diffusion layer which was uniformly transferred to the glass substrate is 95%.

In addition, the glass substrate in which the light diffusion layer was formed was used to manufacture Organic Electroluminescent Device 2 and Organic Electroluminescent Device 2 for reference in the same manner as in the manufacture of Organic Electroluminescent Device 1 of Example 1, and as a result, the light extraction efficiency of Organic Electroluminescent Device 2 was calculated, and found to be 1.7 times.

### (Example 3)

In the manufacture of Light-Diffusing Transfer Sheet 1 of Example 1, Light-Diffusing Transfer Sheet 3 was manufactured in the same manner as in Light-Diffusing Transfer Sheet 1, except that the content ratio of the light scattering particle in the organic film was set to 50% by volume. A light diffusion layer by transfer was formed under the same condition as in Example 1, and as a result, the transfer yield of the light diffusion layer which was uniformly transferred to the glass substrate is 97%.

Furthermore, the glass substrate in which the light diffusion layer was formed was used to manufacture Organic Electroluminescent Device 3 and Organic Electroluminescent Device 3 for reference in the same manner as in the manufacture of Organic Electroluminescent Device 1 of Example 1, and as a result, the light extraction efficiency of Organic Electroluminescent Device 2 was calculated, and found to be 1.7 times.

### (Comparative Example 1)

In the manufacture of Light-Diffusing Transfer Sheet 1 of Example 1, Light-Diffusing Transfer Sheet 4 was manufactured in the same manner as in Light-Diffusing Transfer Sheet 1, except that the content ratio of the light scattering particle in the organic film was set to 10% by volume. A light diffusion layer by transfer was formed under the same condition as in Example 1, and as a result, the transfer yield of the light diffusion layer which was uniformly transferred to the glass substrate is 97%.

In addition, the glass substrate in which the light diffusion layer was formed was used to manufacture Organic Electroluminescent Device 4 and Organic Electroluminescent Device 4 for reference in the same manner as in the manufacture of Organic Electroluminescent Device 1 of Example 1, and as a result, the light extraction efficiency of Organic Electroluminescent Device 4 was calculated, and found to be 1.1 times.

### (Comparative Example 2)

In the manufacture of Light-Diffusing Transfer Sheet 1 of Example 1, Light-Diffusing Transfer Sheet 5 was manufactured in the same manner as in Light-Diffusing Transfer Sheet 1, except that the content ratio of the light scattering particle in the organic film was set to 70% by volume. A light diffusion layer by transfer was formed under the same condition as in Example 1, and as a result, the transfer yield of the light diffusion layer which was uniformly transferred to the glass substrate was 50%.

Furthermore, the glass substrate in which the light diffusion layer was formed was used to manufacture Organic Electroluminescent Device 5 and Organic Electroluminescent Device 5 for reference in the same manner as in the manufacture of Organic Electroluminescent Device 1 of Example 1, and as a result, the light extraction efficiency of Organic Electroluminescent Device 5 was calculated, and found to be 1.7 times.

### (Example 4)

A light diffusion layer by transfer was formed under the same condition as in Example 1, except that Light-Diffusing Transfer Sheet 3 of Example 3 was used and the heating temperature at the time of transferring the organic film was set to 70°C, and as a result, the transfer yield of the light diffusion layer which was uniformly transferred to the glass substrate was 75%.

Further, the glass substrate in which the light diffusion layer was formed was used to manufacture Organic Electroluminescent Device 6 and Organic Electroluminescent Device 6 for reference in the same manner as in the manufacture of Organic Electroluminescent Device 1 of Example 1, and as a result, the light extraction efficiency of Organic Electroluminescent Device 6 was calculated, and found to be 1.7 times.

### (Example 5)

In the manufacture of Light-Diffusing Transfer Sheet 3 of Example 3, a Light-Diffusing Transfer Sheet 6 was manufactured in the same manner as in Light-Diffusing Transfer Sheet 3, except that the film thickness of the organic film was set to 15 µm. A light diffusion layer by transfer was formed under the same condition as in Example 1, and as a result, the transfer yield of the light diffusion layer which was uniformly transferred to the glass substrate was 60%.

In addition, the glass substrate in which the light diffusion layer was formed was used to manufacture Organic Electroluminescent Device 7 and Organic Electroluminescent Device 7 for reference in the same manner as in the manufacture of Organic Electroluminescent Device 1 of Example 1, and as a result, the light extraction efficiency of Organic Electroluminescent Device 7 was calculated, and found to be 1.7 times.

### (Comparative Example 3)

In the manufacture of the light-diffusing transfer sheet 3 of Example 3, Light-Diffusing Transfer Sheet 7 is manufactured in the same manner as in Light-Diffusing Transfer Sheet 3, except that the film thickness of the organic film was set to 2.5 µm. A light diffusion layer by transfer was formed under the same condition as in Example 1, and as a result, the transfer yield of the light diffusion layer which was uniformly transferred to the glass substrate was 97%.

Furthermore, the glass substrate in which the light diffusion layer was formed was used to manufacture Organic Electroluminescent Device 8 and Organic Electroluminescent Device 8 for reference in the same manner as in the manufacture of Organic Electroluminescent Device 1 of Example 1, and as a result, the light extraction efficiency of Organic Electroluminescent Device 8 was calculated, and found to be 1.1 times.

### (Comparative Example 4)

A light diffusion layer by transfer was formed under the same condition as in Example 1, except that Light-Diffusing Transfer Sheet 3 of Example 3 was used and the heating temperature at the time of transferring the organic film was set to 30°C, and as a result, the organic film is left on a part of the support while the light diffusion layer was not uniformly transferred to the glass substrate. The transfer yield of the light diffusion layer which was uniformly transferred to the glass substrate was found to be 0%.

### (Comparative Example 5)

In the manufacture of Light-Diffusing Transfer Sheet 1 of Example 1, a Light-Diffusing Transfer Sheet 8 was manufactured in the same manner as in Light-Diffusing Transfer Sheet 1, except that the content ratio of the light scattering particle in the organic film was set to 20% by volume, and the film thickness of the organic film was set to 10 µm. A light diffusion layer by transfer was formed under the same condition as in Example 1, and as a result, the transfer yield of the light diffusion layer which was uniformly transferred to the glass substrate is 80%.

Further, the glass substrate in which the light diffusion layer was formed was used to manufacture Organic Electroluminescent Device 9 and Organic Electroluminescent Device 9 for reference in the same manner as in the manufacture of Organic Electroluminescent Device 1 of Example 1, and as a result, the light extraction efficiency of Organic Electroluminescent Device 9 was calculated, and found to be 1.3 times.

### (Example 6)

A light diffusion layer by transfer was formed under the same condition as in Example 1, except that in the transfer process to the glass substrate of Example 3, a laminator was used to perform heating and pressurization and then the PET film was peeled off, thereafter, the organic film was cured by irradiating ultraviolet light, and as a result, the transfer yield of the light diffusion layer (organic film) which was uniformly transferred to the glass substrate is 90%.

In addition, the glass substrate in which the light diffusion layer was formed was used to manufacture Organic Electroluminescent Device 10 and Organic Electroluminescent Device 10 for reference in the same manner as in the manufacture of the Organic Electroluminescent Device 1 of Example 1, and as a result, the light extraction efficiency of the Organic Electroluminescent Device 9 was calculated, and found to be 1.65 times.

In the following Table 1, the transfer yields and the light extraction efficiencies of Examples 1 to 6 and Comparative Examples 1 to 5 are summarized. In Comparative Example 4, since a uniform light diffusion layer by transfer may not be formed, an organic electroluminescent device was not manufactured, and accordingly, the light extraction efficiency was not evaluated.

**Table 1**

| | Content ratio N of light-diffusing particle in organic film | Film thickness T of organic film | T×N | Transfer temperature | Transfer yield | Light extraction efficiency |
|---|---|---|---|---|---|---|
| Ex. 1 | 30% | 5 µm | 150 | 120°C | 97% | 1.65 times |
| Ex. 2 | 30% | 8 µm | 240 | 120°C | 95% | 1.7 times |
| Ex. 3 | 50% | 5 µm | 250 | 120°C | 97% | 1.7 times |
| Comp. Ex. 1 | 10% | 5 µm | 50 | 120°C | 97% | 1.1 times |
| Comp. Ex. 2 | 70% | 5 µm | 350 | 120°C | 50% | 1.7 times |
| Ex. 4 | 50% | 5 µm | 250 | 70°C | 75% | 1.7 times |
| Ex. 5 | 50% | 15 µm | 750 | 120°C | 60% | 1.7 times |
| Comp. Ex. 3 | 50% | 2.5 µm | 125 | 120°C | 97% | 1.1 times |
| Comp. Ex. 4 | 50% | 5 µm | 250 | 30°C | 0% | - |
| Comp. Ex. 5 | 20% | 10 µm | 200 | 120°C | 80% | 1.3 times |
| Ex. 6 | 50% | 5 µm | 250 | 120°C | 90% | 1.65 times |

A uniform light diffusion layer may be formed on the glass substrate favorably in terms of transferring property by bonding the light diffusion layer to the glass substrate under the condition of a heating temperature of 60°C or more using a light-diffusing transfer sheet having an organic film in which the content ratio of the light-diffusing particle on the PET film is 25% by volume to 50% by volume, and the content ratio N [% by volume] of the light-diffusing particle and the thickness T [µm] of the organic film satisfy T ≥ 150/N, as shown in Table 1. Further, an organic electroluminescent device having a high light extraction efficiency may be obtained by using a glass substrate in which the light diffusion layer is formed.

### Industrial Applicability

The light-diffusing transfer material of the present invention is excellent in transferring property and may form a light diffusion layer which may enhance the light extraction efficiency of an organic electroluminescent device. In addition, according to the method for forming a light diffusion layer according to the present invention, the light extraction efficiency of the organic electroluminescent device may be enhanced. Furthermore, according to the method for manufacturing an organic electroluminescent device according to the present invention, it is possible to provide an organic electroluminescent device which is excellent in light extraction efficiency.

The organic electroluminescent device of the present invention may be suitably used various fields including, for example, various lighting, a computer, an on-vehicle display, an outdoor display, a household appliance, a business device, a home electronics device, a transportation relationship indicator, a clock display, a calendar display, a luminescent screen, an audio device and the like.

Although the present invention has been described in detail with reference to detailed and specific embodiments, it is obvious to those skilled in the art that various changes or modifications may be made without departing from the spirit and scope of the present invention.

The present application is based on Japanese Patent Application (Patent Application No. 2011-262828) filed on November 30, 2011, the content of which is incorporated herein by reference.

### Reference Signs List

1: Glass substrate
2: Light diffusion layer
3: Planarization layer
4: Transparent electrode
5: Organic electroluminescent layer
6: Reflective electrode
7: Sealing case
8: Barrier layer
10: Organic electroluminescent device
11: Light extraction member
101: Support
102: Organic film
103: Cover film
104: Transfer-receiving material
105: Laminator
106: Ionized radiation
107: Light-diffusing transfer material.

## Claims

1. A light-diffusing transfer material comprising:
an organic film containing at least one kind of light-diffusing particle and at least one high refractive index inorganic filler, on a support,
wherein a content ratio N [% by volume] of the light-diffusing particle in the organic film is in a range from 25 to 50, and
a thickness T [µm] of the organic film satisfies T ≥ 150 N.

2. The light-diffusing transfer material according to claim 1,
wherein a film thickness of the organic film is 4 µm to 15 µm.

3. The light-diffusing transfer material according to claim 1 or 2,
wherein the support contains at least one selected from the group consisting of polyethylene terephthalate, polyethylene naphthalate, polyvinyl alcohol and polyvinyl chloride.

4. A method for forming a light diffusion layer, the method comprising:
bonding a surface having an organic film in the light-diffusing transfer material according to any one of claims 1 to 3 to a transfer-receiving material, and
transferring the organic film to the transfer-receiving material under a condition of a heating temperature of 60°C or more to form the light diffusion layer on the transfer-receiving material.

5. The method according to claim 4,
wherein the heating temperature is 80°C to 150°C.

6. The method according to claim 4 or 5,
wherein the organic film is cured by irradiating ionized radiation on the organic film in the air in a state where the light-diffusing transfer material is bonded to the transfer-receiving material.

7. The method according to claim 4 or 5,
wherein the organic film is cured by irradiating ionized radiation on the organic film after the organic film is transferred to the transfer-receiving material to peel-off the support from the organic film.

8. A method for manufacturing an organic electroluminescent device having a substrate, a light diffusion layer, a transparent electrode, an organic electroluminescent layer and a reflective electrode, in this order, the method comprising forming the light diffusion layer by the forming method according to any one of claims 4 to 7.

9. The method according to claim 8, comprising forming the light diffusion layer on the substrate by using the substrate as a transfer-receiving material.

10. An organic electroluminescent device manufactured by the manufacturing method according to claim 8 or 9.
